# EUROPEAN PATENT APPLICATION

(11) **EP 4 783 762 A1**
(43) Date of publication of application: **29.07.2026**
(21) Application number: 24882832.9
(22) Date of filing: 23.10.2024
(51) Int. Cl.: H05K 7/20, F28D 15/02

(54) **ELECTRONIC DEVICE COMPRISING STRUCTURES FOR DISPERSING HEAT**

(30) Priority: 24.10.2023 KR 20230143386; 05.12.2023 KR 20230174979
(71) Applicant: Samsung Electronics Co., Ltd., Suwon-si, Gyeonggi-do 16677 (KR)
(72) Inventor: AHN, Joseph, Suwon-si Gyeonggi-do 16677 (KR); LEE, Haejin, Suwon-si Gyeonggi-do 16677 (KR); SEO, Dongwoo, Suwon-si Gyeonggi-do 16677 (KR)
(74) Representative: Gulde & Partner
(86) International application number: PCT/KR2024/016217
(87) International publication number: WO 2025/089805

(57) **Abstract**

An electronic device according to one embodiment may comprise a display, an electronic component and a heat diffusion member partially overlapping with the electronic component when viewed from above the display. The heat diffusion member can include: a first plate facing the electronic component; a second plate substantially facing the first plate; a separation structure arranged to have a first flow path and a second flow path; and a wick structure for moving a fluid. The wick structure can include a first wick portion positioned in the first flow path and the second flow path, and a second wick portion positioned on a portion of the first wick portion that corresponds to the second flow path.

## Description

### [Technical Field]

Various embodiments to be described later relate to an electronic device including a structure for dissipating heat.

### [Background Art]

An electronic device may include various electronic components. The electronic device may be miniaturized to be worn by a user or carried by the user. As electronic components disposed in the electronic device perform an operation for responding to a request of the user, heat may be generated in the miniaturized electronic device. The electronic device may require a structure for dissipating heat in the electronic device. For example, the electronic device may include a vapor chamber or a heat pipe for dissipating heat in the electronic device.

The above-described information may be provided as a related art for the purpose of helping understanding of the present disclosure. No argument or decision is made as to whether any of the above descriptions may be applied as a prior art related to the present disclosure.

### [Disclosure]

### [Technical Solution]

According to an embodiment, an electronic device may comprise a display, an electronic component, and a heat spreading member disposed to at least partially overlap the electronic component when viewed from above the display. The heat spreading member may include a first plate facing the electronic component, a second plate substantially facing the first plate, and a separating structure disposed in an internal space between the first plate and the second plate such that a first flow path and a second flow path are respectively formed along a first lateral surface and a second lateral surface opposite to the first lateral surface thereof. The heat spreading member may include a wick structure for moving a fluid along at least one of the first flow path and the second flow path. The wick structure may include a first wick portion located in the first flow path or the second flow path, and a second wick portion located over a portion of the first wick portion corresponding to the second flow path.

According to an embodiment, an electronic device may comprise an electronic component, and a heat spreading member disposed at least partially on the electronic component. The heat spreading member may include a first region facing the electronic component, a second region spaced apart from the first region, and a third region connecting the first region and the second region, and including a first flow path for a fluid in a gaseous state and a second flow path for the fluid in a liquid state. The heat spreading member may include a frame including a separating structure in the third region separating the first flow path and the second flow path, and a wick structure for moving the fluid in the frame. The wick structure may include a first wick portion including a first portion disposed in the first region, a second portion disposed in the second region, and a third portion disposed in the third region and connecting the first portion and the second portion, and a second wick portion disposed in the second flow path and interposed between the third portion and the frame.

### [Description of the Drawings]

FIG. 1 is a block diagram of an electronic device in a network environment according to an embodiment.
FIG. 2A is a diagram representing an electronic device according to an embodiment.
FIG. 2B is an exploded perspective view of an electronic device according to an embodiment.
FIG. 3A illustrates a portion of an exemplary electronic device.
FIG. 3B is an exploded perspective view of a heat spreading member of an exemplary electronic device.
FIGS. 4A and 4B are cross-sectional views of a heat spreading member of an exemplary electronic device cut along line A-A' of FIG. 3A.
FIG. 4C is a cross-sectional view of a heat spreading member of an exemplary electronic device cut along line A-A' of FIG. 3A.
FIG. 4D is a top plan view of a first wick portion of a heat spreading member of FIG. 4C.
FIG. 4E is a cross-sectional view of a heat spreading member of an exemplary electronic device cut along line A-A' of FIG. 3A.
FIG. 4F is a top plan view of a first wick portion of a heat spreading member of FIG. 4D.
FIG. 5A is an exploded perspective view of a heat spreading member of an exemplary electronic device.
FIG. 5B is a cross-sectional view of a heat spreading member of an exemplary electronic device cut along line A-A' of FIG. 3A.
FIG. 5C is a top plan view of a wick structure of a heat spreading member of FIG. 5B.
FIG. 5D is a cross-sectional view of a heat spreading member of an exemplary electronic device cut along line A-A' of FIG. 3A.
FIG. 5E is a top plan view of a wick structure of a heat spreading member of FIG. 5D.
FIGS. 6A, 6B, 6C, and 6D illustrate a portion of a heat spreading member of an exemplary electronic device.
FIGS. 7A, 7B, and 7C illustrate a portion of a heat spreading member of an exemplary electronic device.
FIGS. 8A, 8B, 8C, 8D, and 8E illustrate a portion of an exemplary electronic device.
FIG. 9A illustrates an unfolded state of an exemplary electronic device.
FIG. 9B illustrates a folded state of an exemplary electronic device.
FIG. 9C is an exploded view of an exemplary electronic device.
FIGS. 9D and 9E illustrate a portion of an exemplary electronic device.

### [Mode for Invention]

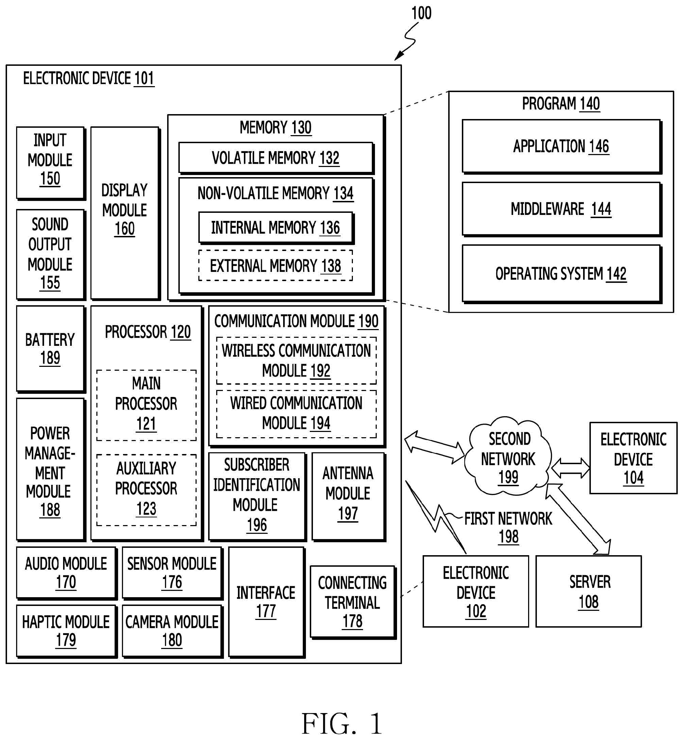

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

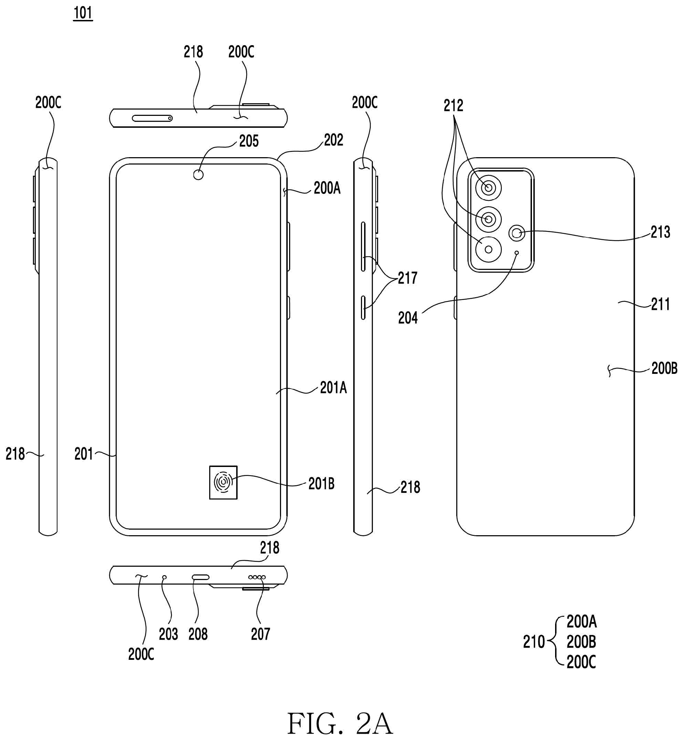

FIG. 2A is a diagram representing an electronic device according to an embodiment.

Referring to FIG. 2A, an electronic device 200 according to an embodiment may include a housing 210 forming an exterior of the electronic device 200. For example, the housing 210 may include a front surface 200A, a rear surface 200B, and a lateral surface 200C surrounding a space between the front surface 200A and the rear surface 200B. According to an embodiment, the housing 210 may also refer to a structure forming at least a portion of the front surface 200A, the rear surface 200B, and/or the lateral surfaces 200C.

The electronic device 200 according to an embodiment may include a substantially transparent front plate 202. According to an embodiment, the front plate 202 may form at least a portion of the front surface 200A. According to an embodiment, the front plate 202 may include, for example, a glass plate including various coating layers or a polymer plate, but is not limited thereto.

The electronic device 200 according to an embodiment may include a substantially opaque rear plate 211. According to an embodiment, the rear plate 211 may form at least a portion of the rear surface 200B. According to an embodiment, the rear plate 211 may be formed of coated or colored glass, ceramic, polymer, metal (e.g., aluminum, stainless steel (STS), or magnesium), or a combination of at least two of the above materials.

The electronic device 200 according to an embodiment may include a side bezel structure (or a side member) 218. According to an embodiment, the side bezel structure 218 may form at least a portion of the lateral surface 200C of the electronic device 200 by being coupled with the front plate 202 and/or the rear plate 211. For example, the side bezel structure 218 may form the entire lateral surface 200C of the electronic device 200, and for another example, the side bezel structure 218 may form the lateral surface 200C of the electronic device 200 together with the front plate 202 and/or the rear plate 211.

Unlike the illustrated embodiment, in a case that the lateral surface 200C of the electronic device 200 is partially formed by the front plate 202 and/or the rear plate 211, the front plate 202 and/or the rear plate 211 may include a region that is bent from its periphery toward the rear plate 211 and/or the front plate 202 and seamlessly extends. The extending region of the front plate 202 and/or the rear plate 211 may be located, for example, at both ends of a long edge of the electronic device 200, but is not limited to the above-described example.

According to an embodiment, the side bezel structure 218 may include metal and/or polymer. According to an embodiment, the rear plate 211 and the side bezel structure 218 may be integrally formed and may include the same material (e.g., a metal material such as aluminum), but are not limited thereto. For example, the rear plate 211 and the side bezel structure 218 may be formed as separate configurations and/or may include different materials.

According to an embodiment, the electronic device 200 may include at least one of a display 201, audio modules 203, 204, and 207, a sensor module (not illustrated), camera modules 205, 212, and 213, a key input device 217, a light emitting element (not illustrated), and/or a connector hole 208. According to an embodiment, the electronic device 200 may omit at least one (e.g., the key input device 217 or the light emitting element (not illustrated)) of the components or may additionally include another component.

According to an embodiment, the display 201 may be visually exposed through a significant portion of the front plate 202. For example, at least a portion of the display 201 may be visible through the front plate 202 forming the front surface 200A. According to an embodiment, the display 201 may be disposed on a back surface of the front plate 202.

According to an embodiment, an outer shape of the display 201 may be formed substantially the same as an outer shape of the front plate 202 adjacent to the display 201. According to an embodiment, in order to expand an area in which the display 201 is visually exposed, a gap between an outer periphery of the display 201 and an outer periphery of the front plate 202 may be formed substantially the same.

According to an embodiment, the display 201 (or the front surface 200A of the electronic device 200) may include a screen display region 201A. According to an embodiment, the display 201 may provide visual information to a user through the screen display region 201A. In the illustrated embodiment, it is illustrated that the screen display region 201A is spaced apart from an outer periphery of the front surface 200A and is located on an inner side of the front surface 200A when the front surface 200A is viewed from the front, but is not limited thereto. In another embodiment, at least a portion of a periphery of the screen display region 201A may substantially coincide with a periphery of the front surface 200A (or the front plate 202), when the front surface 200A is viewed from the front.

According to an embodiment, the screen display region 201A may include a sensing region 201B configured to obtain biometric information of the user. Herein, a meaning of "the screen display region 201A includes the sensing region 201B" may be understood as at least a portion of the sensing region 201B being overlapped with the screen display region 201A. For example, the sensing region 201B may mean a region that may display visual information by the display 201 similarly to another region of the screen display region 201A and additionally obtain the biometric information (e.g., fingerprint) of the user. According to an embodiment, the sensing region 201B may be formed in the key input device 217.

According to an embodiment, the display 201 may include a region in which a first camera 205 is located. According to an embodiment, an opening may be formed in the region of the display 201, and the first camera 205 (e.g., a punch hole camera) may be at least partially disposed in the opening to face the front surface 200A. In this case, the screen display region 201A may surround at least a portion of a periphery of the opening. According to an embodiment, the first camera 205 (e.g., an under display camera (UDC)) may be disposed under the display 201 to overlap the region of the display 201. In this case, the display 201 may provide visual information to the user through the region, and additionally, the first camera 205 may obtain an image corresponding to a direction facing the front surface 200A through the region of the display 201.

According to an embodiment, the display 201 may be coupled with or disposed adjacent to touch sensing circuitry, a pressure sensor capable of measuring an intensity (pressure) of a touch, and/or a digitizer that detects a magnetic field type stylus pen.

According to an embodiment, the audio modules 203, 204, and 207 may include microphone holes 203 and 204 and a speaker hole 207.

According to an embodiment, the microphone holes 203 and 204 may include a first microphone hole 203 formed in a partial region of the lateral surface 200C and a second microphone hole 204 formed in a partial region of the rear surface 200B. A microphone (not illustrated) for obtaining external sound may be disposed inside the microphone holes 203 and 204. The microphone may include a plurality of microphones to sense a direction of sound.

According to an embodiment, the second microphone hole 204 formed in the partial region of the rear surface 200B may be disposed adjacent to the camera modules 205, 212, and 213. For example, the second microphone hole 204 may obtain sound according to an operation of the camera modules 205, 212, and 213. However, it is not limited thereto.

According to an embodiment, the speaker hole 207 may include an external speaker hole 207 and a call receiver hole (not illustrated). The external speaker hole 207 may be formed in a portion of the lateral surface 200C of the electronic device 200. According to an embodiment, the external speaker hole 207 may be implemented as one hole with the microphone hole 203. Although not illustrated, the call receiver hole (not illustrated) may be formed in another portion of the lateral surface 200C. For example, the call receiver hole may be formed on an opposite side of the external speaker hole 207 on the lateral surface 200C. For example, based on the illustration of FIG. 2A, the external speaker hole 207 may be formed on the lateral surface 200C corresponding to a lower portion of the electronic device 200, and the call receiver hole may be formed on the lateral surface 200C corresponding to an upper portion of the electronic device 200. However, it is not limited thereto, and according to an embodiment, the call receiver hole may be formed at a location other than the lateral surface 200C. For example, the call receiver hole may be formed by a separated space between the front plate 202 (or the display 201) and the side bezel structure 218.

According to an embodiment, the electronic device 200 may include at least one speaker (not illustrated) configured to output sound to the outside of the housing through the external speaker hole 207 and/or the call receiver hole (not illustrated).

According to an embodiment, the sensor module (not illustrated) may generate an electrical signal or a data value corresponding to an internal operating state of the electronic device 200 or an external environmental state. For example, the sensor module may include at least one of a proximity sensor, an HRM sensor, a fingerprint sensor, a gesture sensor, a gyro sensor, a barometric sensor, a magnetic sensor, an acceleration sensor, a grip sensor, a color sensor, an infrared (IR) sensor, a biometric sensor, a temperature sensor, a humidity sensor, or an illuminance sensor.

According to an embodiment, the camera modules 205, 212, and 213 may include the first camera 205 disposed to face the front surface 200A of the electronic device 200, a second camera 212 disposed to face the rear surface 200B, and a flash 213.

According to an embodiment, the second camera 212 may include a plurality of cameras (e.g., a dual camera, a triple camera, or a quad camera). However, the second camera 212 is not necessarily limited to including the plurality of cameras, and may include one camera.

According to an embodiment, the first camera 205 and the second camera 212 may include one or a plurality of lenses, an image sensor, and/or an image signal processor.

According to an embodiment, the flash 213 may include, for example, a light emitting diode or a xenon lamp. According to an embodiment, two or more lenses (an infrared camera and wide-angle and telephoto lenses) and image sensors may be disposed on one surface of the electronic device 200.

According to an embodiment, the key input device 217 may be disposed on the lateral surface 200C of the electronic device 200. According to an embodiment, the electronic device 200 may not include a portion or all of the key input device 217, and the key input device 217 that is not included may be implemented in another form, such as a soft key, on the display 201.

According to an embodiment, the connector hole 208 may be formed on the lateral surface 200C of the electronic device 200 to accommodate a connector of an external device. A connection terminal electrically connected to the connector of the external device may be disposed in the connector hole 208. The electronic device 200 according to an embodiment may include an interface module for processing an electrical signal transmitted and received through the connection terminal.

According to an embodiment, the electronic device 200 may include the light emitting element (not illustrated). For example, the light emitting element (not illustrated) may be disposed on the front surface 200A of the housing. The light emitting element (not illustrated) may provide state information of the electronic device 200 in the form of light. According to an embodiment, the light emitting element (not illustrated) may provide a light source linked with an operation of the first camera 205. For example, the light emitting element (not illustrated) may include an LED, an IR LED, and/or a xenon lamp.

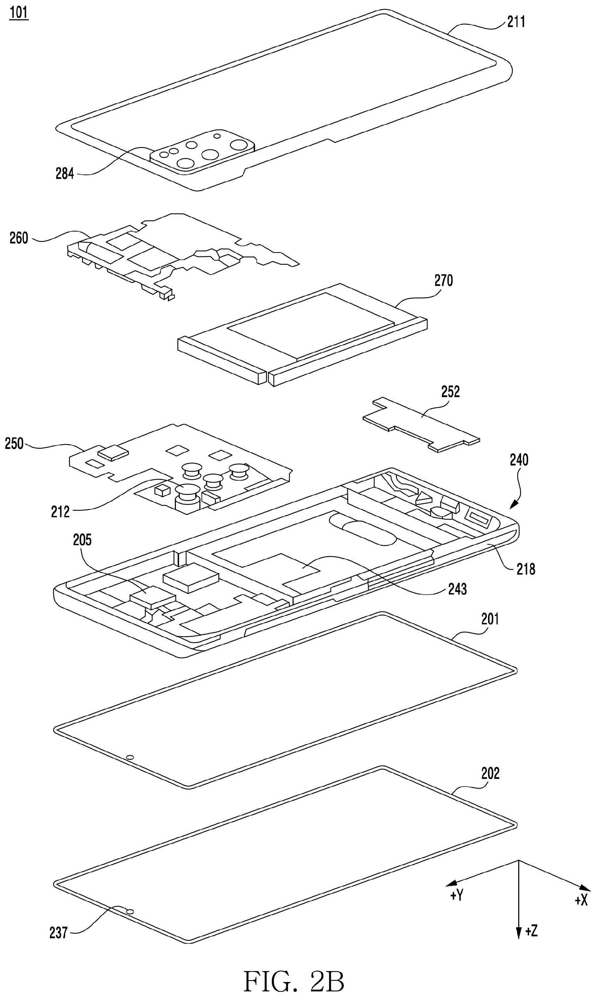

FIG. 2B is an exploded perspective view of an electronic device according to an embodiment.

Hereinafter, overlapping descriptions of configurations having the same reference numerals as the above-described configuration will be omitted.

Referring to FIG. 2B, an electronic device 200 according to an embodiment may include a frame structure 240, a first printed circuit board 250, a second printed circuit board 252, a cover plate 260, and a battery 270.

According to an embodiment, the frame structure 240 may include a side bezel structure 218 forming an exterior (e.g., the lateral surface 200C of FIG. 2A) of the electronic device 200 and a supporting portion 243 extending inward from the side bezel structure 218. According to an embodiment, the frame structure 240 may be disposed between a display 201 and a rear plate 211. According to an embodiment, the side bezel structure 218 of the frame structure 240 may surround a space between the rear plate 211 and a front plate 202 (and/or the display 201), and the supporting portion 243 of the frame structure 240 may extend from the side bezel structure 218 in the space.

According to an embodiment, the frame structure 240 may support or accommodate other components included in the electronic device 200. For example, the display 201 may be disposed on a surface of the frame structure 240 facing a direction (e.g., a +z direction), and the display 201 may be supported by the supporting portion 243 of the frame structure 240. For example, the first printed circuit board 250, the second printed circuit board 252, the battery 270, and a second camera 212 may be disposed on another surface of the frame structure 240 facing an opposite direction (e.g., a -z direction) to the direction. The first printed circuit board 250, the second printed circuit board 252, the battery 270, and the second camera 212 may be respectively seated in a recess defined by the side bezel structure 218 and/or the supporting portion 243 of the frame structure 240.

According to an embodiment, the first printed circuit board 250, the second printed circuit board 252, and the battery 270 may be respectively coupled with the frame structure 240. For example, the first printed circuit board 250 and the second printed circuit board 252 may be fixedly disposed in the frame structure 240 through a coupling member such as a screw. For example, the battery 270 may be fixedly disposed on the frame structure 240 through an adhesive member (e.g., a double-sided tape). However, it is not limited to the above-described example.

According to an embodiment, the cover plate 260 may be disposed between the first printed circuit board 250 and the rear plate 211. According to an embodiment, the cover plate 260 may be disposed on the first printed circuit board 250. For example, the cover plate 260 may be disposed on a surface of the first printed circuit board 250 facing the -z direction.

According to an embodiment, the cover plate 260 may at least partially overlap the first printed circuit board 250 based on a z-axis. According to an embodiment, the cover plate 260 may cover at least a partial region of the first printed circuit board 250. Accordingly, the cover plate 260 may protect the first printed circuit board 250 from a physical impact or prevent a connector coupled to the first printed circuit board 250 from being separated.

According to an embodiment, the cover plate 260 may be fixedly disposed on the first printed circuit board 250 through a coupling member (e.g., a screw), or may be coupled to the frame structure 240 together with the first printed circuit board 250 through the coupling member.

According to an embodiment, the display 201 may be disposed between the frame structure 240 and the front plate 202. For example, the front plate 202 may be disposed on a side (e.g., in the +z direction) of the display 201, and the frame structure 240 may be disposed on another side (e.g., in the -z direction).

According to an embodiment, the front plate 202 may be coupled with the display 201. For example, the front plate 202 and the display 201 may be adhered to each other through an optical adhesive member (e.g., optically clear adhesive (OCA) or optically clear resin (OCR)) interposed therebetween.

According to an embodiment, the front plate 202 may be coupled to the frame structure 240. For example, the front plate 202 may include an outer portion extending outside the display 201 when viewed in a z-axis direction, and may be attached to the frame structure 240 through an adhesive member (e.g., a double-sided tape) disposed between the outer portion of the front plate 202 and the frame structure 240 (e.g., the side bezel structure 218). However, it is not limited to the above-described example.

According to an embodiment, a processor, memory, and/or an interface may be mounted on the first printed circuit board 250 and/or the second printed circuit board 252. The processor may include, for example, one or more of a central processing unit, an application processor, a graphics processing unit, an image signal processor, a sensor hub processor, or a communication processor. The memory may include, for example, a volatile memory or a non-volatile memory. The interface may include, for example, a high definition multimedia interface (HDMI), a universal serial bus (USB) interface, an SD card interface, and/or an audio interface. The interface may electrically or physically connect the electronic device 200 to an external electronic device, and may include a USB connector, an SD card/MMC connector, or an audio connector. According to an embodiment, the first printed circuit board 250 and the second printed circuit board 252 may be operatively or electrically connected to each other through a connection member (e.g., a flexible printed circuit board).

According to an embodiment, the battery 270 may supply power to at least one component of the electronic device 200. For example, the battery 270 may include a rechargeable secondary battery or a fuel cell. At least a portion of the battery 270 may be disposed on substantially the same plane as the first printed circuit board 250 and/or the second printed circuit board 252.

The electronic device 200 according to an embodiment may include an antenna module (not illustrated). According to an embodiment, the antenna module may be disposed between the rear plate 211 and the battery 270. The antenna module may include, for example, a near field communication (NFC) antenna, a wireless charging antenna, and/or a magnetic secure transmission (MST) antenna. The antenna module may, for example, perform short-range communication with an external device or wirelessly transmit and receive power with an external device.

According to an embodiment, a first camera 205 (e.g., a front camera) may be disposed in at least a portion (e.g., the supporting portion 243) of the frame structure 240 so that a lens may receive external light through a partial region (e.g., a camera region 237) of the front plate 202 (e.g., the front surface 200A of FIG. 1).

According to an embodiment, a second camera 212 (e.g., a rear camera) may be disposed between the frame structure 240 and the rear plate 211. According to an embodiment, the second camera 212 may be electrically connected to the first printed circuit board 250 through a connection member (e.g., a connector). According to an embodiment, the second camera 212 may be disposed so that a lens may receive external light through a camera region 284 of the rear plate 211 of the electronic device 200.

According to an embodiment, the camera region 284 may be formed on a surface (e.g., the rear surface 200B of FIG. 1) of the rear plate 211. According to an embodiment, the camera region 284 may be formed to be at least partially transparent so that external light may be incident on the lens of the second camera 212. According to an embodiment, at least a portion of the camera region 284 may protrude from the surface of the rear plate 211 by a predetermined height. However, it is not limited thereto, and in another embodiment, the camera region 284 may form substantially the same plane as the surface of the rear plate 211.

According to an embodiment, a housing (e.g., the housing 210 of FIG. 2A) of the electronic device 200 may mean a configuration or a structure forming at least a portion of the exterior of the electronic device 200. In this regard, at least a portion of the front plate 202, the frame structure 240, and/or the rear plate 211 forming the exterior of the electronic device 200 may be referred to as the housing 210 of the electronic device 200.

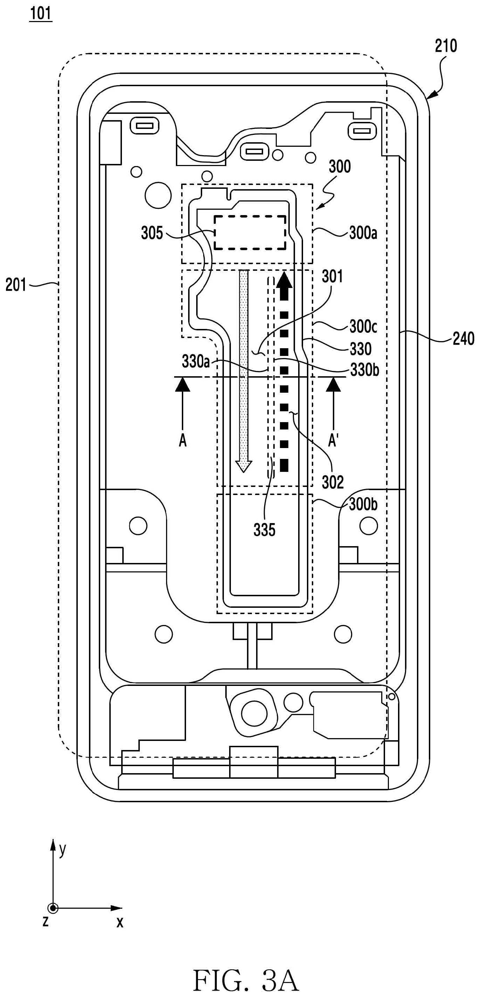

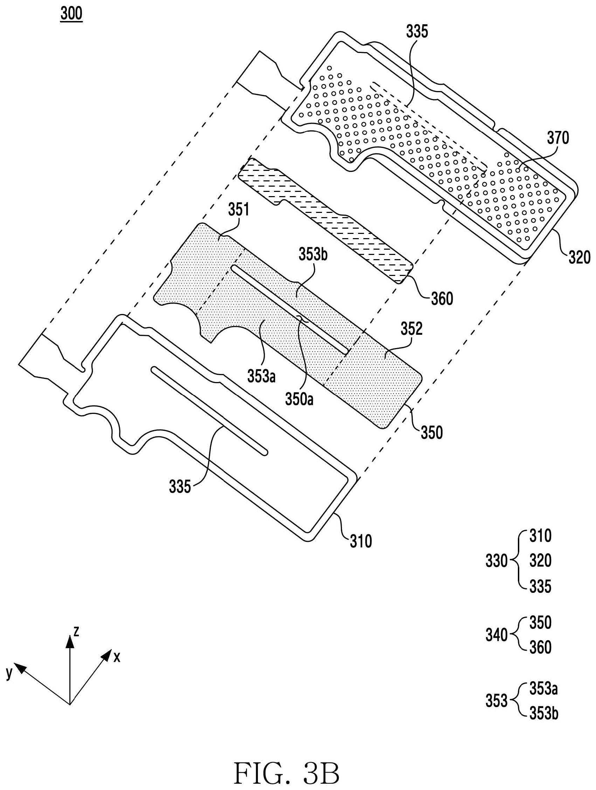

FIG. 3A illustrates a portion of an exemplary electronic device. FIG. 3B is an exploded perspective view of a heat spreading member of an exemplary electronic device.

Referring to FIGS. 3A and 3B, an electronic device 101 may include an electronic component 305 and a heat spreading member 300.

According to an embodiment, the heat spreading member 300 may be at least partially disposed on the electronic component 305. In this document, when an element is mentioned as being "on" another element, it should be understood that it may be directly on the another element or that intervening elements may be present therebetween. For example, in this document, "B disposed on A" may represent "B disposed over A". For example, in this document, "B disposed on A" may represent "B facing A and spaced apart from A". For example, "the heat spreading member 300 disposed on the electronic component 305" may mean "the heat spreading member 300 contacting the electronic component 305". For example, "the heat spreading member 300 disposed on the electronic component 305" may mean "the heat spreading member 300 facing the electronic component 305 and spaced apart from the electronic component 305".

For example, the heat spreading member 300 may at least partially overlap the electronic component 305 when the heat spreading member 300 is viewed from above (e.g., when viewed from a +z direction). For example, the heat spreading member 300 may be disposed over the electronic component 305 based on the +z direction. For example, although not illustrated, the heat spreading member 300 may be disposed under the electronic component 305 based on the +z direction. For example, the heat spreading member 300 may receive at least a portion of heat emitted from the electronic component 305 by at least partially facing the electronic component 305.

For example, the electronic component 305 may be mounted on a printed circuit board (e.g., the first printed circuit board 250 or the second printed circuit board 252 of FIG. 2B) of the electronic device 101. A surface of the printed circuit board on which the electronic component 305 is disposed may face the heat spreading member 300. For example, the electronic component 305 may emit heat to a surrounding of the electronic component 305 by being configured to perform a computation as the electronic device 101 operates. The heat spreading member 300 may dissipate the heat emitted from the electronic component 305 by being at least partially disposed on the electronic component 305. For example, the electronic component 305 may be referred to as a processor (e.g., the processor 120 of FIG. 1) of the electronic device 101, but is not limited thereto.

For example, the electronic device 101 may include a housing 210. The electronic component 305 and the heat spreading member 300 may be disposed in the housing 210. The housing 210 may include a frame structure 240 for supporting and fastening the heat spreading member 300 in the housing 210. For example, at least a portion of the frame structure 240 may provide a seating space for accommodating the heat spreading member 300. For example, at least a portion of the frame structure 240 may be disposed between the electronic component 305 and the heat spreading member 300. The at least a portion of the frame structure 240 may transfer at least a portion of the heat emitted from the electronic component 305 to the heat spreading member 300. For example, at least a portion (e.g., the supporting portion 243 of FIG. 2B) of the frame structure 240 may be disposed such that heat emitted from the electronic component 305 toward a display (e.g., the display 201 of FIG. 2A) of the electronic device 101 is dissipated through the heat spreading member 300, by supporting the heat spreading member 300. A structure for dissipating the heat through the heat spreading member 300 will be described later.

According to an embodiment, the heat spreading member 300 may include a first region 300a facing the electronic component 305, a second region 300b spaced apart from the first region 300a, and a third region 300c connecting the first region 300a and the second region 300b. The third region 300c may include a first flow path 301 for a fluid in a gaseous state and a second flow path 302 for the fluid in a liquid state.

For example, the heat spreading member 300 may include a fluid (not illustrated) disposed in the heat spreading member 300 to dissipate heat transferred to the heat spreading member 300. The fluid may be vaporizable by heat transferred from the electronic component 305 to the heat spreading member 300. The fluid may be liquefied as heat is emitted from the heat spreading member 300. The fluid may be, for example, water, but is not limited thereto.

For example, the first region 300a may be a region that receives heat from the electronic component 305. For example, the first region 300a may be a region overlapping the electronic component 305 when viewed from above (e.g., when viewed from the +z direction). The first region 300a may be a region disposed on the electronic component 305. For example, the first region 300a may be a region that receives at least a portion of heat emitted from the electronic component 305 through a component (e.g., the frame structure 240) between the electronic component 305 and the first region 300a. For example, a fluid in the first region 300a may be vaporized from a liquid state to a gaseous state by heat transferred from the electronic component 305. The fluid in the first region 300a may absorb the heat by being vaporized. The first region 300a may be referred to as an evaporation portion of the heat spreading member 300 in terms of a region where the fluid vaporizes, but is not limited thereto.

For example, the second region 300b may be a region having a lower temperature than the first region 300a. For example, a fluid in the second region 300b may be liquefied from a gaseous state to a liquid state. The fluid in the second region 300b may emit heat from the second region 300b by being liquefied. The second region 300b may be referred to as a condensation portion of the heat spreading member 300 in terms of a region where the fluid liquefies, but is not limited thereto.

For example, the third region 300c may be configured to move a fluid in a gaseous state from the first region 300a to the third region 300c through the first flow path 301. The third region 300c may be configured to move the fluid in a liquid state from the second region 300b to the first region 300a through the second flow path 302.

For example, the third region 300c may extend from the first region 300a to the second region 300b. For example, the third region 300c may be disposed between the first region 300a and the second region 300b. For example, the third region 300c may provide a movement path of a fluid between the first region 300a and the second region 300b. For example, the first flow path 301 may be a path for a fluid vaporized in the first region 300a to move to the third region 300b. The fluid in a gaseous state vaporized in the first region 300a may move to the third region 300b through the first flow path 301. For example, the second flow path 302 may be a path for a fluid liquefied in the third region 300b to move to the first region 300a. The fluid in a liquid state liquefied in the third region 300b may be moved to the first region 300a through the second flow path 302. The heat spreading member 300 may be referred to as a loop heat pipe in terms of having a structure in which a fluid in the heat spreading member 300 is moved from the first region 300a to the second region 300b or is moved from the second region 300b to the first region 300a through a phase change, but is not limited thereto. The heat spreading member 300 may dissipate heat transferred from the electronic component 305 to the heat spreading member 300 by being configured to circulate the fluid in the heat spreading member 300. The heat spreading member 300 may require, for the circulation of the fluid, a structure for separating the first flow path 301 for the fluid in the gaseous state and the second flow path 302 for the fluid in the liquid state.

According to an embodiment, the first flow path 301 may be configured to spread a fluid substantially vaporized by heat generated from the electronic component 305 from the first region 300a of the heat spreading member 300 through the first flow path 301 to the second region 300b opposite to the first region 300a. The second flow path 302 may be configured to spread the fluid substantially liquefied in the second region 300b from the second region 300b through the second flow path 302 to the first region 300a.

According to an embodiment, the heat spreading member 300 may include a first plate 310, a second plate 320 coupled with the first plate 310, and a frame 330 including a separating structure 335 in the third region 300c separating the first flow path 301 and the second flow path 302.

For example, the frame 330 may form an exterior of the heat spreading member 300. The frame 330 may include metal having a relatively high thermal conductivity, but is not limited thereto. For example, the first plate 310 may be a plate supported by the housing 210 (or the frame structure 240). For example, the first plate 310 may be a plate that receives heat from the electronic component 305. For example, the second plate 320 may be disposed on the first plate 310. The second plate 320 may be fastened to the first plate 310. For example, the second plate 320 may seal an internal space of the heat spreading member 300 together with the first plate 310. For example, the second plate 320 may form the regions 300a, 300b, and 300c of the heat spreading member 300 together with the first plate 310.

For example, the separating structure 335 may space the first flow path 301 apart from the second flow path 302 in the third region 300c. For example, the separating structure 335 may separate a fluid in a gaseous state moving through the first flow path 301 from a fluid in a liquid state moving through the second flow path 302 in the frame 330. For example, the separating structure 335 may extend in a direction from the first region 300a toward the second region 300b (e.g., a -y direction) and/or in a direction from the second region 300b toward the first region 300a (e.g., a +y direction). For example, the separating structure 335 may be disposed between the first plate 310 and the second plate 320.

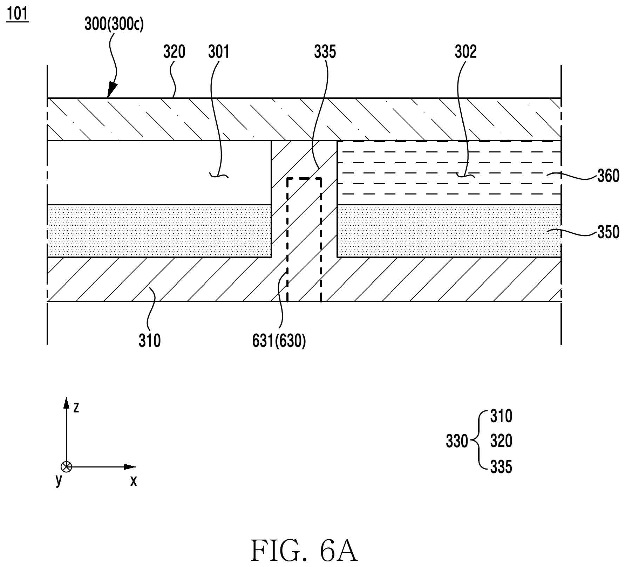

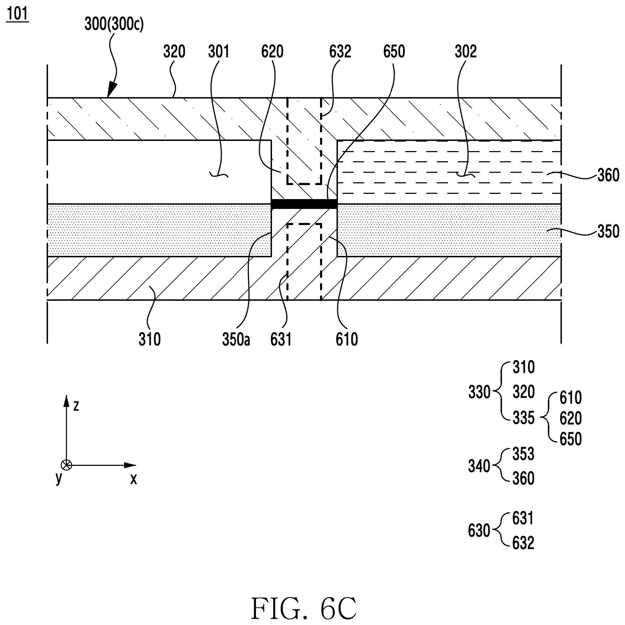

According to an embodiment, the separating structure 335 may at least partially protrude from the first plate 310 or may protrude from the second plate 320. For example, in a case that the separating structure 335 protrudes from the first plate 310 toward the second plate 320, the separating structure 335 may support the second plate 320. The separating structure 335 may reduce damage to the third region 300c due to an external impact by supporting the second plate 320. For example, in a case that the separating structure 335 protrudes from the second plate 320 toward the first plate 310, the separating structure 335 may support the first plate 310. The separating structure 335 may reduce damage to the third region 300c due to an external impact by supporting the first plate 310. For example, a portion (e.g., a first protrusion 610 of FIG. 6C) of the separating structure 335 may protrude from the first plate 310 toward the second plate 320, and a remaining portion (e.g., a second protrusion 620 of FIG. 6C) of the separating structure 335 may protrude from the second plate 320 toward the first plate 310. The portion of the separating structure 335 and the remaining portion of the separating structure 335 may be in contact with each other or may be coupled with each other by an element (e.g., an adhesive member 650 of FIG. 6C) between therein. Regarding formation of the separating structure 335, it will be described later in FIG. 6A and below. By including the separating structure 335, the heat spreading member 300 may reduce damage to the third region 300c due to an external impact by separating the first flow path 301 for a fluid in a gaseous state from the second flow path 302 for the fluid in a liquid state and reinforcing rigidity of the third region 300c.

According to an embodiment, the separating structure 335 may be disposed in an internal space between the first plate 310 and the second plate 320 such that the first flow path 301 and the second flow path 302 are respectively formed along a first lateral surface 330a and a second lateral surface 330b opposite to the first lateral surface 330a of the separating structure 335. For example, the first flow path 301 may be at least partially formed by the first lateral surface 330a of the separating structure 335. The fluid in the first flow path 301 may be in contact with the first lateral surface 330a of the separating structure 335. For example, the second flow path 302 may be at least partially formed by the second lateral surface 330b opposite to the first lateral surface 330a of the separating structure 335. The fluid in the second flow path 302 may be in contact with the second lateral surface 330b.

According to an embodiment, the heat spreading member 300 may include a wick structure 340 for moving a fluid in the frame 330. The wick structure 340 may include a first wick portion 350 attached to the first plate 310 of the frame 330, and a second wick portion 360 disposed in the second flow path 302 and at least partially interposed between the first wick portion 350 and the second plate 320 of the frame 330.

For example, the wick structure 340 may include a porous structure for absorbing a fluid in a liquid state in the heat spreading member 300. For example, the wick structure 340 may be disposed between the first plate 310 and the second plate 320. For example, the first wick portion 350 may be in contact with the first plate 310. The first wick portion 350 may receive, through the first plate 310, at least a portion of heat emitted from the electronic component 305. For example, in the first region 300a, a fluid in a liquid state included in the first wick portion 350 may be vaporized by heat transferred from the electronic component 305 to the first region 300a. The vaporized fluid in a gaseous state may be moved to the second region 300b through the first flow path 301 of the third region 300c. For example, the fluid in the gaseous state in the second region 300b may be liquefied by dissipating heat from the second region 300b. At least a portion of the liquefied fluid in a liquid state may be absorbed into the first wick portion 350.

For example, the second wick portion 360 may be at least partially disposed in the second flow path 302 for a fluid in a liquid state. In the second flow path 302, a portion of the first wick portion 350 and at least a portion of the second wick portion 360 may be disposed. For example, the second wick portion 360 may be disposed at least partially between the first wick portion 350 and the second plate 320, in the second flow path 302. The second wick portion 360 may be attached to the second plate 320. For example, the second wick portion 360 may be attached on the first wick portion 350. The second wick portion 360 may move the fluid in the liquid state in the second flow path 302, together with the first wick portion 350. The wick structure 340 may provide a path for moving the fluid in the liquid state from the second region 300b to the first region 300a, by including the second wick portion 360 disposed in the second flow path 302.

According to an embodiment, the first wick portion 350 may include a first portion 351 disposed in the first region 300a, a second portion 352 disposed in the second region 300b, and a third portion 353 in the third region 300c connecting the first portion 351 and the second portion 352. The third portion 353 may include, to support the second plate 320, a first supporting region 353a disposed in the first flow path 301 and a second supporting region 353b disposed in the second flow path 302.

For example, the first portion 351 may be attached to the first plate 310 in the first region 300a. The first portion 351 may be disposed over the electronic component 305. For example, the first portion 351 may receive heat from the electronic component 305 through the first plate 310. A fluid in a liquid state included in the first portion 351 may be vaporized in the first region 300a through the heat. For example, the second portion 352 may be spaced apart from the first portion 351. The second portion 352 may absorb the fluid liquefied by dissipating heat in the second region 300b.

For example, the third portion 353 may extend from the first portion 351 to the second portion 352. For example, the third portion 353 may move a fluid in a liquid state from the second region 300b to the first region 300a. For example, the first supporting region 353a may be attached to the first plate 310 in the first flow path 301. The first supporting region 353a may move a fluid in a liquid state included in the first supporting region 353a toward the first region 300a. For example, the second supporting region 353b may be separated from the first supporting region 353a by being attached to the first plate 310 in the second flow path 302. The second supporting region 353b may move a fluid in a liquid state included in the second supporting region 353b toward the first region 300a. For example, the second supporting region 353b may be in contact with the second wick portion 360. The second supporting region 353b may be a portion attached to the second wick portion 360 among the third portion 353 in the third region 300c. The first wick portion 350 may improve performance of the heat spreading member 300 for dissipating heat by including the first supporting region 353a disposed in the first flow path 301 and the second supporting region 353b disposed in the second flow path 302.

According to an embodiment, the first wick portion 350 may include a slit 350a for passing through the separating structure 335. For example, the slit 350a may be penetrated by the separating structure 335 in the third region 300c. For example, the slit 350a may fasten the first wick portion 350 to the frame 330 by being coupled with the separating structure 335. For example, the slit 350a may have a shape corresponding to a shape of the separating structure 335. For example, the slit 350a may be disposed between the first supporting region 353a and the second supporting region 353b of the third portion 353. The slit 350a may separate the first supporting region 353a and the second supporting region 353b. By including the slit 350a, the first wick portion 350 may provide a space for the separating structure 335 and may be fastened to the frame 330.

According to an embodiment, the frame 330 may include a plurality of pillars 370 protruding from the second plate 320 toward the first plate 310. For example, the plurality of pillars 370 may extend from the second plate 320 toward the first plate 310 in the frame 330. For example, the plurality of pillars 370 may be attached to the first wick portion 350 by extending from the second plate 320 toward the first wick portion 350. For example, pressure in the heat spreading member 300 may be lower than pressure outside the heat spreading member 300. Since the pressure in the heat spreading member 300 is lower than the pressure outside the heat spreading member 300, the frame 330 of the heat spreading member 300 may be at least partially dented due to an external impact. The second plate 320 may reduce damage to the frame 330 due to an external impact by including the plurality of pillars 370 supported by the first wick portion 350 and/or the first plate 310.

According to the above-described embodiment, the heat spreading member 300 of the electronic device 101 may reduce damage to other electronic components in the electronic device 101 by heat emitted from the electronic component 305, by being configuring to dissipate the heat emitted from the electronic component 305. The heat spreading member 300 may improve performance of the heat spreading member 300 for dissipating the heat and reduce damage to the frame 330 of the heat spreading member 300 due to an external impact, by including the separating structure 335 for separating the first flow path 301 for moving the fluid in the gaseous state and the second flow path 302 for moving the fluid in the liquid state. The heat spreading member 300 may move the fluid in the liquid state from the second region 300b to the first region 300a through the wick structure 340 disposed in the frame 330. The wick structure 340 may improve the performance of the heat spreading member 300 by including the second wick portion 360 at least partially disposed in the second flow path 302.

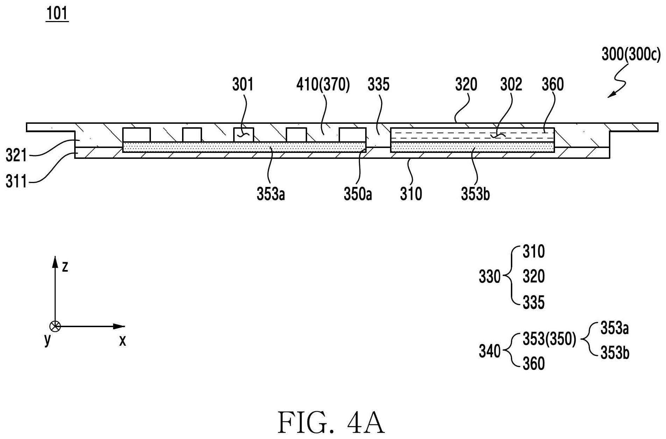

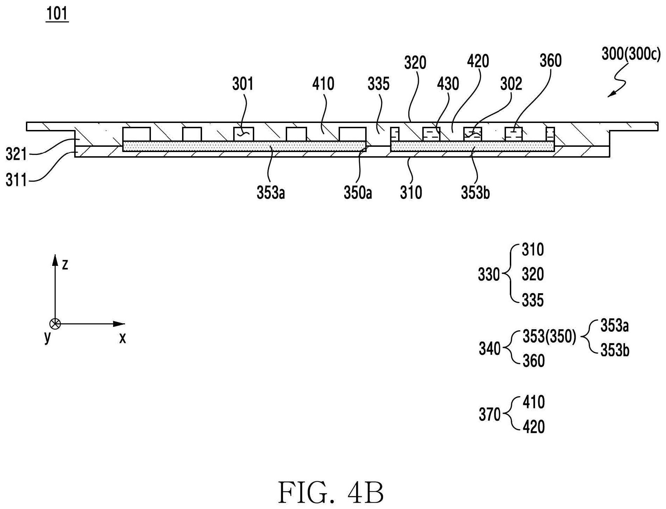

FIGS. 4A and 4B are cross-sectional views of a heat spreading member of an exemplary electronic device cut along line A-A' of FIG. 3A.

Referring to FIGS. 4A and 4B, an electronic device 101 may include an electronic component (e.g., the electronic component 305 of FIG. 3A) and a heat spreading member 300 at least partially disposed on the electronic component 305. The heat spreading member 300 may include a first region (e.g., the first region 300a of FIG. 3A) facing the electronic component 305, a second region (e.g., the second region 300b of FIG. 3A) spaced apart from the first region 300a, and a third region 300c connecting the first region 300a and the second region 300b, and including a first flow path 301 for a fluid in a gaseous state, and a second flow path 302 for the fluid in a liquid state. The heat spreading member 300 may include a first plate 310, a second plate 320 coupled with the first plate 310, a frame 330 including a separating structure 335 in the third region 300c separating the first flow path 301 and the second flow path 302, and a wick structure 340 for moving the fluid in the frame 330. The wick structure 340 may include a first wick portion 350 attached to the first plate 310, and a second wick portion 360 disposed in the second flow path 302 and at least partially interposed between the first wick portion 350 and the second plate 320. According to an embodiment, the frame 330 may include a plurality of pillars 370 protruding from the second plate 320 toward the first plate 310.

According to an embodiment, the first wick portion 350 may include a first portion (e.g., the first portion 351 of FIG. 3B) disposed in the first region 300a, a second portion (e.g., the second portion 352 of FIG. 3B) disposed in the second region 300b, and a third portion 353 disposed in the third region 300c and connecting the first portion 351 and the second portion 352. The third portion 353 may include, to support the second plate 320, a first supporting region 353a disposed in the first flow path 301 and a second supporting region 353b disposed in the second flow path 302.

Hereinafter, overlapping descriptions of configurations having the same reference numerals as described in FIGS. 3A and 3B will be omitted.

According to an embodiment, the second wick portion 360 may fill the second flow path 302 together with the first wick portion 350. For example, the second wick portion 360 may occupy a space between the first wick portion 350 and the second plate 320 in the second flow path 302. For example, the second flow path 302 may be filled by the second supporting region 353b of the first wick portion 350 and the second wick portion 360 attached on the second supporting region 353b. For example, the second wick portion 360 may be surrounded, in the second flow path 302, by the third supporting region 353b of the first wick portion 350 and the second plate 320. For example, the second wick portion 350 may be attached to the separating structure 335. For example, the second wick portion 360 may be covered by the second plate 320 in the second flow path 302. The wick structure 340 may move a fluid in a liquid state in the heat spreading member 300 from the second region 300b to the first region 300a through the second flow path 302 by including the second wick portion 360 filling the second flow path 302 together with the first wick portion 350.

According to an embodiment, the first plate 310 may include a first side wall 311 disposed along a periphery of the first plate 310. The second plate 320 may include a second side wall 321 disposed along a periphery of the second plate 320 and facing the first side wall 311. The second side wall 321 may be coupled with the first side wall 311. For example, the second side wall 321 may be attached on the second side wall 311. The second side wall 321, for example, may be welded to the first side wall 311. For example, the second side wall 321 may seal a space between the first plate 310 and the second plate 320 together with the first side wall 311. The second side wall 321 may reduce leakage of the fluid in the heat spreading member 300 by sealing the inside of the heat spreading member 300 together with the first side wall 311. The second side wall 321 may couple the second plate 320 to the first plate 310 by being coupled to the first side wall 311.

According to an embodiment, the frame 330 may include first pillars 410 in contact with the first supporting region 353a by protruding from the second plate 320 toward the first plate 310 in the first flow path 301. For example, the first pillars 410 may extend from the second plate 320 to the first supporting region 353a. For example, the first pillars 410 may be attached on the first supporting region 353a. The first supporting region 353a may be at least partially disposed between the first pillars 410 and the second plate 320. For example, the first pillars 410 may be in contact with the fluid in the gaseous state in the first flow path 301. The first pillars 410 may support the second plate 320 on which the first pillars 410 are formed. The first pillars 410 may be supported by the first plate 310. The second plate 320 may reduce damage to the first flow path 301 due to an external impact by including the first pillars 410 supported by the first wick portion 350 and/or the first plate 310.

Referring to FIG. 4B, the frame 330 may include second pillars 420 in contact with the second supporting region 353b by protruding from the second plate 320 toward the first plate 310 in the second flow path 302. The second wick portion 360 may include a plurality of through holes 430 for passing the second pillars 420 in the second flow path 302. For example, the plurality of pillars 370 may include the first pillars 410 disposed in the first flow path 301 and the second pillars 420 disposed in the second flow path 302. The first pillars 410 and the second pillars 420 may be attached to the first wick portion 350 by protruding from the second plate 320 toward the first plate 310. For example, the second pillars 420 may extend from the second plate 320 to the second supporting region 353b. For example, the second pillars 420 may be attached on the second supporting region 353b. The second supporting region 353b may support the second plate 320 through the second pillars 420. For example, the second pillars 420 may be in contact with the fluid in the liquid state in the second flow path 302. The frame 330 may reduce damage to the second flow path 302 due to an external impact by including the second pillars 420 supported by the second supporting region 353b of the first wick portion 350 and/or the first plate 310.

For example, the plurality of through holes 430 of the second wick portion 360 may be penetrated by the second pillars 420 in the second flow path 302. The plurality of through holes 430 may have a shape corresponding to a shape of the plurality of pillars 420, respectively. For example, the plurality of through holes 430 may be coupled with the second pillars 420. The plurality of through holes 430 may fasten the second wick portion 360 to the second plate 320 by being coupled with the second pillars 420. By including the plurality of through holes 430, the second wick portion 360 may provide a space for the second pillars 420 in the second flow path 302 and couple the second wick portion 360 to the second plate 320.

It has been described that the second wick portion 360 includes the plurality of through holes 430, but is not limited thereto. The second wick portion 360 may include a plurality of recesses for accommodating each of the second pillars 420 instead of the plurality of through holes 430, or may include the plurality of through holes 430 and a plurality of recesses for respectively passing and/or accommodating the second pillars 420 having various shapes. By including the plurality of recesses, the second wick portion 360 may provide a space for the second pillars 420 and reduce damage to the second flow path 302 due to an external impact.

According to the above-described embodiment, the heat spreading member 300 of the electronic device 101 may improve performance of the heat spreading member 300 by including the second wick portion 360 filling the second flow path 302 together with the first wick portion 350. The heat spreading member 300 may reduce damage to the first flow path 301 due to an external impact by including the first pillars 410 protruding from the second plate 320 toward the first plate 310 in the first flow path 301. The heat spreading member 300 may reduce damage to the second flow path 302 due to an external impact by including the second pillars 420 protruding from the second plate 320 toward the first plate 310 in the second flow path 302.

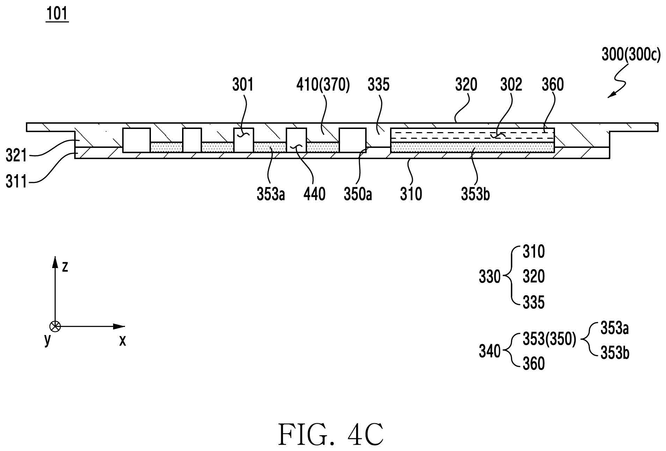

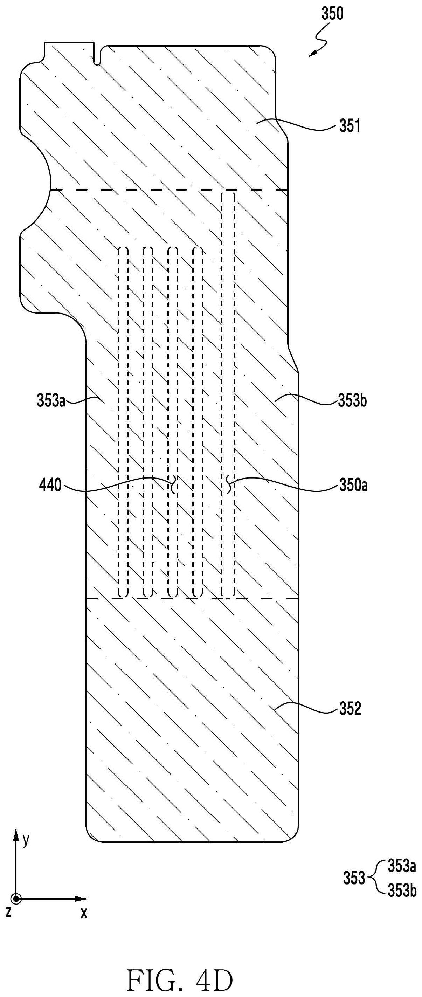

FIG. 4C is a cross-sectional view of a heat spreading member of an exemplary electronic device cut along line A-A' of FIG. 3A. FIG. 4D is a top plan view of a first wick portion of a heat spreading member of FIG. 4C.

Referring to FIGS. 4C and 4D, the frame 330 may include the first pillars 410 in contact with the first supporting region 353a of the first wick portion 350 by protruding from the second plate 320 toward the first plate 310 in the first flow path 301. The first supporting region 353a may include a plurality of holes 440.

For example, the plurality of holes 440 may extend in a direction (e.g., a -y direction) from the first portion 351 toward the second portion 352 and/or in a direction (e.g., a +y direction) from the second portion 352 toward the first portion 351. For example, the plurality of holes 440 may extend along a slit 350a of the first wick portion 350 for passing the separating structure 335. For example, the second supporting plate 320 may face the first supporting plate 310 through the plurality of holes 440 in the first flow path 301. For example, the plurality of holes 440 may be formed in a remaining portion of the first supporting region 353a that is not attached to the first pillars 410.

It has been described that the first supporting region 353a of the first wick portion 350 includes the plurality of holes 440, but is not limited thereto. The first wick portion 350 may include a plurality of recesses for providing an additional space to the first flow path 301 instead of the plurality of holes 440, or may include a structure in which the plurality of holes 440 and a plurality of recesses are formed. The first wick portion 350 may provide an additional space to the first flow path 301 for a fluid in a gaseous state by including the plurality of holes 440 and/or the plurality of recesses.

According to the above-described embodiment, the wick structure 340 in the heat spreading member 300 may provide an additional space for the fluid in the gaseous state in the first flow path 301 by including the first wick portion 350 in which the plurality of holes 440 are formed in the first flow path 301. A remaining portion of the first wick portion 350 excluding a portion in which the plurality of holes 440 are formed may reduce damage to the frame 330 due to an external impact by being attached to the first pillars 410 in the first flow path 301.

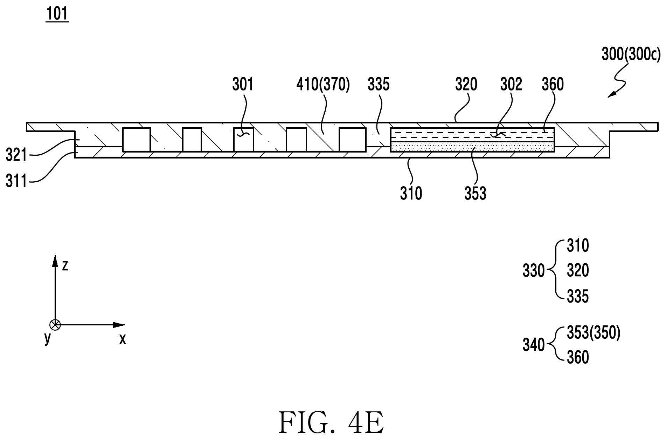

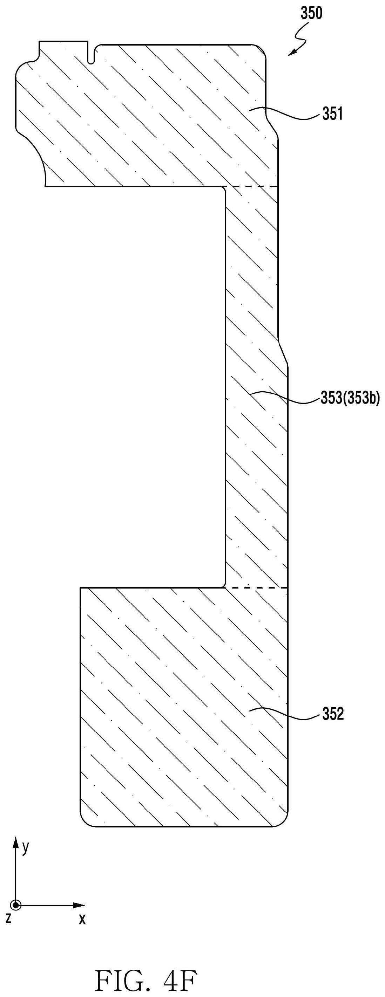

FIG. 4E is a cross-sectional view of a heat spreading member of an exemplary electronic device cut along line A-A' of FIG. 3A. FIG. 4F is a top plan view of a first wick portion of a heat spreading member of FIG. 4D.

Referring to FIGS. 4E and 4F, the frame 330 may include the first pillars 410 protruding from the second plate 320 toward the first plate 310 in the first flow path 301. The first pillars 410 may be in contact with the first plate 310.

For example, unlike FIGS. 4A to 4D, the first supporting region 353a of the first wick portion 350 may be omitted. For example, the third portion 353 of the first wick portion 350 may be disposed in the second flow path 302 among the first flow path 301 and the second flow path 302. For example, the first pillars 410 may extend from the second plate 320 to the first plate 310. The first pillars 410 may be attached to the first plate 310. For example, the first pillars 410 may support the second plate 320 through the first plate 310.

For example, a fluid in a liquid state in the heat spreading member 300 may be moved through the third portion 353 and the second wick portion 360 in the second flow path 302 among the first flow path 301 and the second flow path 302. The fluid in the liquid state in the first wick portion 350 may move from the second portion 352 through the third portion 353 in the second flow path 302 to the first portion 351. The fluid in a gaseous state in the heat spreading member 300 may be moved through the first flow path 301 among the first flow path 301 and the second flow path 302.

The structure of the first flow path 301 and the second flow path 302 described above and illustrated in FIGS. 4A to 4F is exemplary and is not limited thereto. The first flow path 301 and the second flow path 302 of the electronic device 101 may include various structures and a combination of the structures according to the frame 330 and the wick structure 340 forming the first flow path 301 and the second flow path 302. For example, in an embodiment, the first flow path 301 may include a structure in which the plurality of holes 440 are formed in the first wick portion 350 as illustrated in FIG. 4C, and the second flow path 302 may include a structure in which the plurality of through holes 430 for the second pillars 420 are formed in the second wick portion 360 as illustrated in FIG. 4B. For example, in an embodiment, the first flow path 301 may include a structure in which the first wick portion 350 is not disposed and the first pillars 410 extend to the first plate 310 as illustrated in FIG. 4E, and the second flow path 302 may include a structure in which the plurality of through holes 430 for the second pillars 420 are formed in the second wick portion 460 as illustrated in FIG. 4B. However, it is not limited thereto, and shapes of the first flow path 301 and the second flow path 302 may include a combination of the structures exemplified in FIGS. 4A to 4F.

According to the above-described embodiment, the first wick portion 350 in the heat spreading member 300 may improve performance of the heat spreading member 300 by being disposed in the second flow path 302 among the first flow path 301 and the second flow path 302 in the third region 300c. As the heat spreading member 300 includes first pillars 410 attached to the first plate 310 by extending from the second plate 320 to the first plate 310, the heat spreading member 300 may reduce damage to the frame 330 due to an external impact.

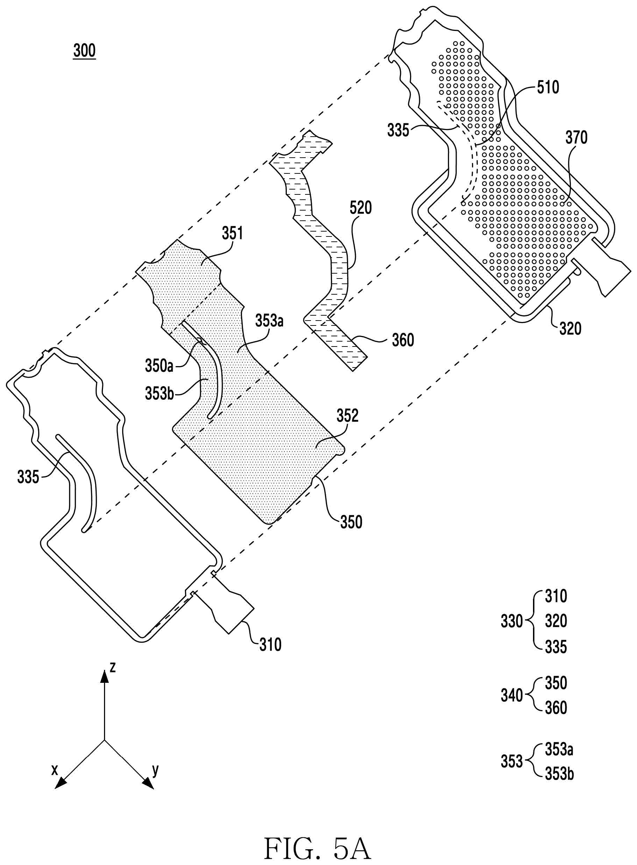

FIG. 5A is an exploded perspective view of a heat spreading member of an exemplary electronic device.

Referring to FIG. 5A, an electronic device (e.g., the electronic device 101 of FIG. 1) may include an electronic component (e.g., the electronic component 305 of FIG. 3A) and a heat spreading member 300 at least partially disposed on the electronic component 305. The heat spreading member 300 may include a first region (e.g., the first region 300a of FIG. 3A) facing the electronic component 305, a second region (e.g., the second region 300b of FIG. 3A) spaced apart from the first region 300a, and a third region (e.g., the third region 300c of FIG. 3A) connecting the first region 300a and the second region 300b, and including a first flow path (e.g., the first flow path 301 of FIG. 3A) for a fluid in a gaseous state, and a second flow path (e.g., the second flow path 302 of FIG. 3A) for the fluid in a liquid state. The heat spreading member 300 may include a first plate 310, a second plate 320 coupled with the first plate 310, a frame 330 including a separating structure 335 in the third region 300c separating the first flow path 301 and the second flow path 302, and a wick structure 340 for moving the fluid in the frame 330. The wick structure 340 may include a first wick portion 350 attached to the first plate 310, and a second wick portion 360 disposed in the second flow path 302 and at least partially interposed between the first wick portion 350 and the second plate 320.

According to an embodiment, the separating structure 335 may have a curvature by being at least partially bent. For example, at least a portion of the regions 300a, 300b, and 300c of the heat spreading member 300 may be bent. The separating structure 335 in the heat spreading member 300 may be bent along at least a portion of the bent heat spreading member 300.

For example, the separating structure 335 may include at least one first bending portion 510 having a curvature. The first flow path 301 and/or the second flow path 302 in the third region 300c of the heat spreading member 300 may have a shape bent by the at least one first bending portion 510. For example, the second wick portion 360 disposed at least partially in the second flow path 302 may include at least one second bending portion 520 bent to correspond to the at least one first bending portion 510 of the separating structure 335. A third portion 353 (or a second supporting region 353b) of the first wick portion 350 attached to the second wick portion 360 may be at least partially bent to correspond to the at least one first bending portion 510 and/or the at least one second bending portion 520. However, it is not limited thereto. The heat spreading member 300 may require a frame 330 having at least a partially bent shape by structures in a housing (e.g., the housing 210 of FIG. 2A) of the electronic device 101. The separating structure 335 and/or the wick structure 340 in the frame 330 may be configured, by being at least partially bent along the at least partially bent frame 330, such that the heat spreading member 300 is disposed in the electronic device 101.

According to the above-described embodiment, the heat spreading member 300 of the electronic device 101 may be configured, by including the separating structure 335 having the at least one first bending portion 510 and/or the second wick portion 360 having the at least one second bending portion 520 along the at least partially bent frame 330, such that the heat spreading member 300 is disposed in the electronic device 101.

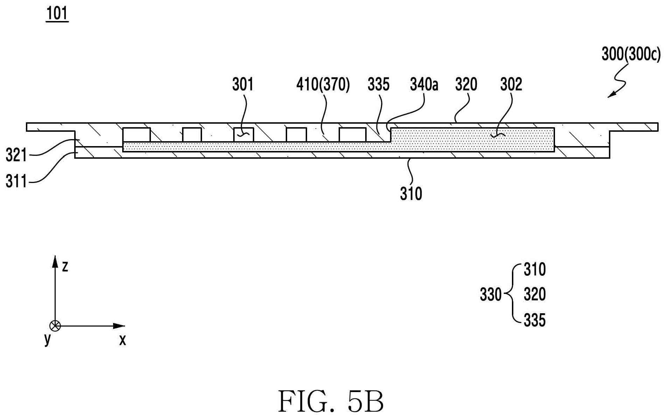

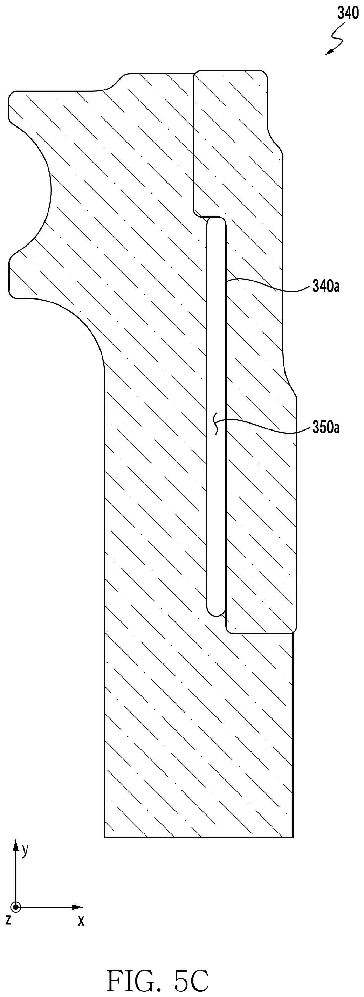

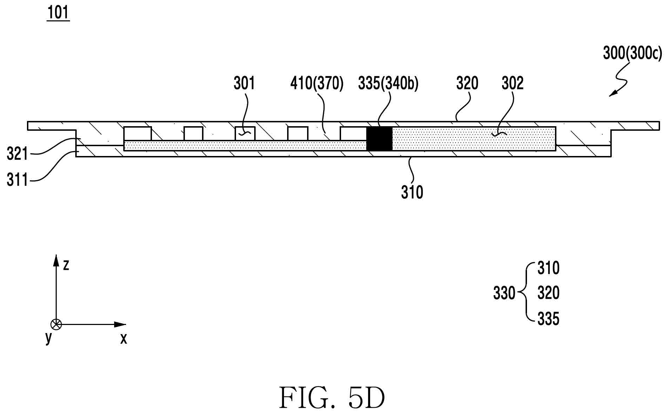

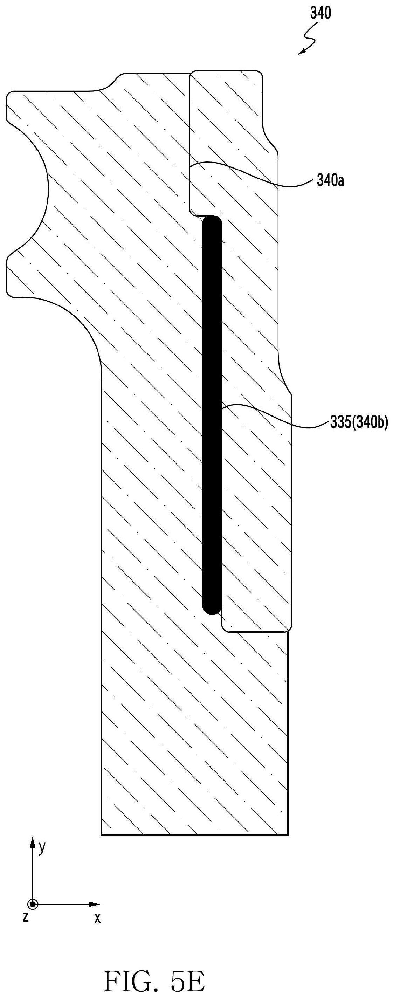

FIG. 5B is a cross-sectional view of a heat spreading member of an exemplary electronic device cut along line A-A' of FIG. 3A. FIG. 5C is a top plan view of a wick structure of a heat spreading member of FIG. 5B. FIG. 5D is a cross-sectional view of a heat spreading member of an exemplary electronic device cut along line A-A' of FIG. 3A. FIG. 5E is a top plan view of a wick structure of a heat spreading member of FIG. 5D.

Referring to FIGS. 5B, 5C, 5D, and 5E, an electronic device 101 may include an electronic component (e.g., the electronic component 305 of FIG. 3A) and a heat spreading member 300 at least partially disposed on the electronic component 305. The heat spreading member 300 may include a first region (e.g., the first region 300a of FIG. 3A) facing the electronic component 305, a second region (e.g., the second region 300b of FIG. 3A) spaced apart from the first region 300a, and a third region 300c connecting the first region 300a and the second region 300b, and including a first flow path 301 for a fluid in a gaseous state, and a second flow path 302 for the fluid in a liquid state. The heat spreading member 300 may include a first plate 310, a second plate 320 coupled with the first plate 310, a frame 330 including a separating structure 335 in the third region 300c separating the first flow path 301 and the second flow path 302, and a wick structure 340 for moving the fluid in the frame 330. The wick structure 340 may include a first wick portion 350 attached to the first plate 310, and a second wick portion 360 disposed in the second flow path 302 and at least partially interposed between the first wick portion 350 and the second plate 320. According to an embodiment, the frame 330 may include a plurality of pillars 370 protruding from the second plate 320 toward the first plate 310.

According to an embodiment, unlike FIGS. 3A to 5A, the wick structure 340 may be a structure in which the first wick portion (e.g., the first wick portion 350 of FIG. 3B) and the second wick portion (e.g., the second wick portion 360 of FIG. 3B) are integrally formed. For example, among the wick structures 340, the first wick structure 340 may be a portion with a relatively small thickness for first pillars 410 disposed in the first flow path 301. For example, among the wick structure 340, the second wick portion 350 may be a portion with a relatively large thickness for filling the second flow path 302.

According to an embodiment, the wick structure 340 may include a step portion 340a formed along the separating structure 335. For example, the step portion 340a may be formed by a difference in thickness between the first wick portion 350 and the second wick portion 360. For example, a height of the step portion 340a may correspond to a height of each of the first pillars 410 disposed in the first flow path 301. The wick structure 340 may be configured to simplify a manufacturing process of the wick structure 340 and move a fluid in the heat spreading member 300, by including an integrally formed structure including the step portion 340a.

Referring to FIGS. 5B and 5C, the wick structure 340 may include a slit 350a for passing the separating structure 335. The step portion 340a of the wick structure 340 may be formed along the slit 350a.

Referring to FIGS. 5D and 5E, unlike FIGS. 5A to 5C, the slit 350a may be omitted in the wick structure 340. The wick structure 340 may include a separating portion 340b functioning as the separating structure 335. For example, the separating portion 340b may be welded to the first plate 310 and the second plate 320. For example, the separating portion 340b may be a portion of the wick structure 340 in which an unprocessed base material of the wick structure 340 is disposed. For example, in a case that the wick structure 340 is a mesh wick, the separating portion 340b may be a portion in which a mesh structure is not formed. The wick structure 340 may separate the first flow path 301 and the second flow path 302 by including the separating portion 340b functioning as the separating structure 335.

According to the above-described embodiment, the wick structure 340 of the heat spreading member 300 may be configured to simplify the manufacturing process of the wick structure 340 and move the fluid in the heat spreading member 300, by including the step portion 340a and including an integrally formed structure. The wick structure 340 may separate the first flow path 301 and the second flow path 302 by including the separating portion 340b.

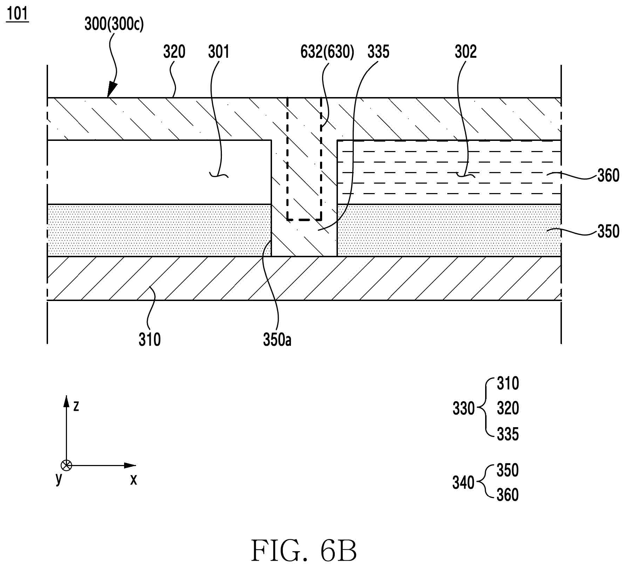

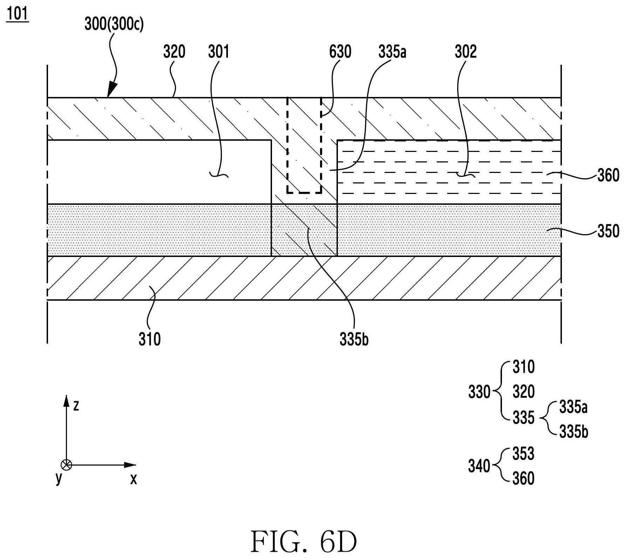

FIGS. 6A, 6B, 6C, and 6D illustrate a portion of a heat spreading member of an exemplary electronic device.

Referring to FIGS. 6A, 6B, 6C, and 6D, an electronic device 101 may include an electronic component (e.g., the electronic component 305 of FIG. 3A) and a heat spreading member 300 at least partially disposed on the electronic component 305. The heat spreading member 300 may include a first region (e.g., the first region 300a of FIG. 3A) facing the electronic component 305, a second region (e.g., the second region 300b of FIG. 3A) spaced apart from the first region 300a, and a third region 300c connecting the first region 300a and the second region 300b, and including a first flow path 301 for a fluid in a gaseous state, and a second flow path 302 for the fluid in a liquid state. The heat spreading member 300 may include a first plate 310, a second plate 320 coupled with the first plate 310, a frame 330 including a separating structure 335 in the third region 300c separating the first flow path 301 and the second flow path 302, and a wick structure 340 for moving the fluid in the frame 330. The wick structure 340 may include a first wick portion 350 attached to the first plate 310, and a second wick portion 360 disposed in the second flow path 302 and at least partially interposed between the first wick portion 350 and the second plate 320.

Referring to FIG. 6A, the separating structure 335 may be in contact with the second plate 320 by extending from the first plate 310 toward the second plate 320 in the third region 300c. For example, the separating structure 335 may be formed in the first plate 310. The separating structure 335 may space the first flow path 301 apart from the second flow path 302 by protruding from the first plate 310 toward the second plate 320. For example, the separating structure 335 may reduce the second plate 320 from being recessed toward the first plate 310 due to an external impact by supporting the second plate 320.

Referring to FIG. 6B, the separating structure 335 may be in contact with the first plate 310 by extending from the second plate 320 toward the first plate 310 in the third region 300c. For example, the separating structure 335 may be formed in the second plate 320. The separating structure 335 may space the first flow path 301 apart from the second flow path 302 by protruding from the second plate 320 toward the first plate 310. For example, the separating structure 335 may reduce the first plate 310 from being recessed toward the second plate 320 due to an external impact by supporting the first plate 310.

Referring to FIG. 6C, the separating structure 335 may include a first protrusion 610 extending from the first plate 310 toward the second plate 320 in the third region 300c, a second protrusion 620 facing the first protrusion 610 by extending from the second plate 320 toward the first plate 310 in the third region 300c, and an adhesive member 650 connecting the first protrusion 610 and the second protrusion 620. For example, the first protrusion 610 may be disposed at a location corresponding to the second protrusion 620 among the first plate 310. For example, the first protrusion 610 may overlap the second protrusion 620 when viewed from above (e.g., when viewed in a +z direction). For example, the first protrusion 610 may be coupled with the second protrusion 620.

For example, the adhesive member 650 may be interposed between the first protrusion 610 and the second protrusion 620. The adhesive member 650 may attach the first protrusion 610 to the second protrusion 620. For example, the adhesive member 650 may fill a gap between the first protrusion 610 and the second protrusion 620. The adhesive member 650 may separate the first flow path 301 and the second flow path 302 by being disposed in the gap. For example, the adhesive member 650 may include a solder for coupling the first protrusion 610 and the second protrusion 620, but is not limited thereto.

It has been described that the adhesive member 650 is disposed between the first protrusion 610 and the second protrusion 620 of the separating structure 335, but is not limited thereto. For example, when referring to FIG. 6A together, the adhesive member 650 may attach the separating structure 335 to the second plate 320 by being disposed between the separating structure 335 extending from the first plate 310 toward the second plate 320 and the second plate 320. For example, when referring to FIG. 6B together, the adhesive member 650 may attach the separating structure 335 to the first plate 310 by being disposed between the separating structure 335 extending from the second plate 320 toward the first plate 310 and the first plate 310.

Referring to FIG. 6D, the separating structure 335 may include a first supporting portion 335a protruding from the second plate 320 toward the first wick portion 350, and a second supporting portion 335b connected to the first supporting portion 335a and at least partially filling the first wick portion 350. For example, unlike those illustrated in FIGS. 6A to 6C, the slit 350a for passing the separating structure 335 of the first wick portion 350 may be omitted. At least a portion of the first wick portion 350 may be filled with a material forming the separating structure 335. For example, the first supporting portion 335a may be a portion in contact with a fluid in a gaseous state moving through the first flow path 301. For example, the first supporting portion 335a may be a portion in contact with the second wick portion 360 disposed in the second flow path 302. For example, the second supporting portion 335b may be a portion disposed in the first wick portion 350 through a porous structure of the first wick portion 350. For example, the second supporting portion 335b may be a portion disposed between the first plate 310 and the first supporting portion 335a in the first wick portion 350. For example, the second supporting portion 335b may separate the first flow path 301 and the second flow path 302 by extending from the first supporting portion 335a through the first wick portion 350 to the first plate 310. For example, as the first supporting portion 335a is attached to the first plate 310, the separating structure 335 may be fastened to the second plate 320.

Referring again to FIGS. 6A, 6B, 6C, and 6D, the frame 330 may include at least one recess 630 formed in the separating structure 335.

For example, in a case that the separating structure 335 of the frame 330 is formed through an etching process, the separating structure 335 may not include the at least one recess 630. For example, in a case that the separating structure 335 of the frame 330 is formed through machining, the separating structure 335 may include the at least one recess 630 by being formed through press processing into at least a portion of the first plate 310 and/or at least a portion of the second plate 320.

For example, when referring to FIG. 6A, the separating structure 335 may protrude from the first plate 310 toward the second plate 320. The first plate 310 may include a first recess 631 disposed at a location corresponding to the separating structure 335 and recessed toward the second plate 320. For example, when referring to FIG. 6B, the separating structure 335 may protrude from the second plate 320 toward the first plate 310. The second plate 320 may include a second recess 632 disposed at a location corresponding to the separating structure 335 and recessed toward the first plate 310.

For example, when referring to FIG. 6C, the separating structure 335 may include the first protrusion 610 protruding from the first plate 310 toward the second plate 320, and the second protrusion 620 protruding from the second plate 320 toward the first plate 310 and facing the first protrusion 610. The at least one recess 630 may include the first recess 631 formed in the first protrusion 610 and recessed toward the second plate 320, and the second recess 632 formed in the second protrusion 620 and recessed toward the first plate 310.

According to an embodiment, the wick structure 340 may include at least one of a mesh wick and a sintering wick. For example, the first wick portion 350 and the second wick portion 360 may be the mesh wick. For example, the first wick portion 350 and the second wick portion 360 may be the sintering wick. For example, one of the first wick portion 350 and the second wick portion 360 may be the mesh wick, and another one may be the sintering wick. However, it is not limited thereto. The wick structure 340 may improve performance of the heat spreading member 300 by including at least one of the mesh wick and the sintering wick.

According to the above-described embodiment, by including the separating structure 335 in the heat spreading member 300 separating the first flow path 301 and the second flow path 302, the heat spreading member 300 of the electronic device 101 may improve the performance of the heat spreading member 300 and reduce damage to the third region 300c in which the separating structure 335 is disposed due to an external impact.

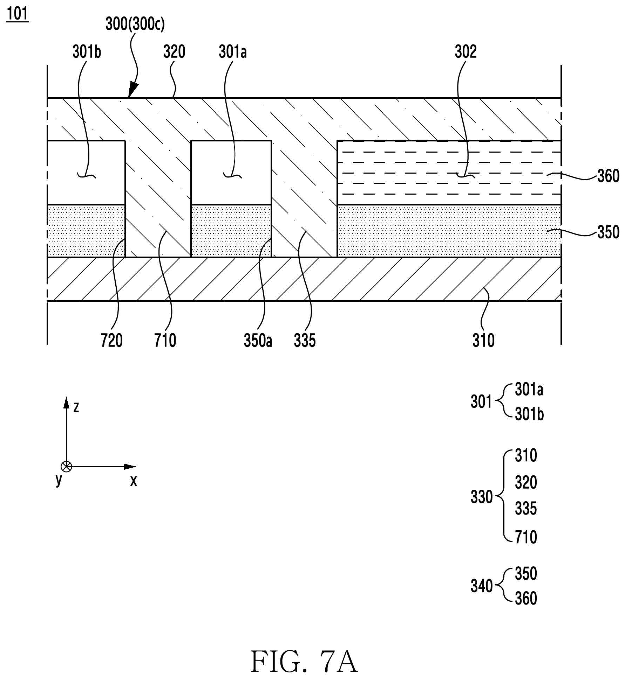

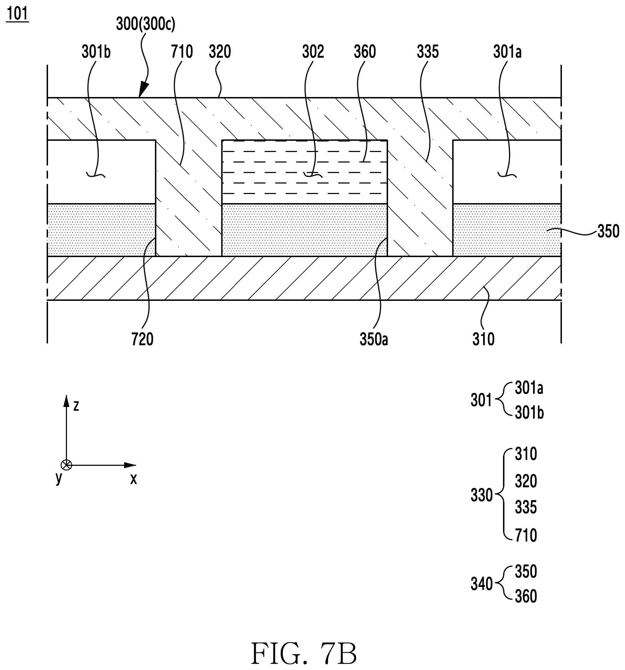

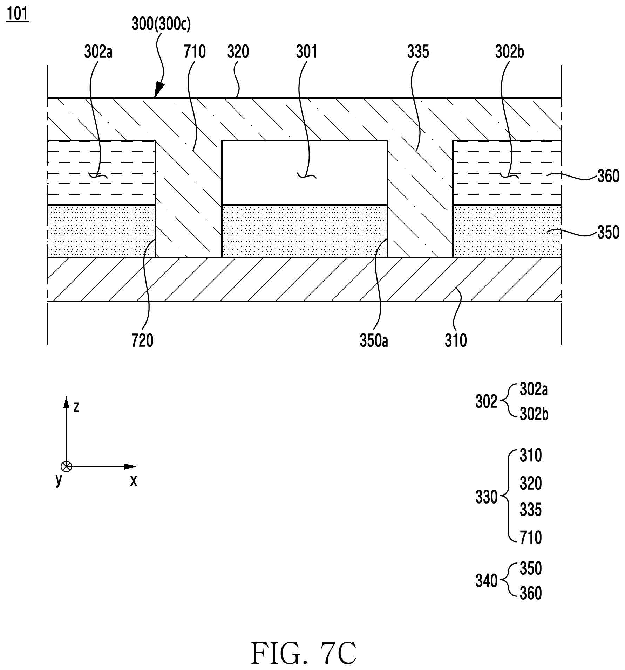

FIGS. 7A, 7B, and 7C illustrate a portion of a heat spreading member of an exemplary electronic device.

Referring to FIGS. 7A, 7B, and 7C, an electronic device 101 may include an electronic component (e.g., the electronic component 305 of FIG. 3A) and a heat spreading member 300 at least partially disposed on the electronic component 305. The heat spreading member 300 may include a first region (e.g., the first region 300a of FIG. 3A) facing the electronic component 305, a second region (e.g., the second region 300b of FIG. 3A) spaced apart from the first region 300a, and a third region 300c connecting the first region 300a and the second region 300b, and including a first flow path 301 for a fluid in a gaseous state, and a second flow path 302 for the fluid in a liquid state. The heat spreading member 300 may include a first plate 310, a second plate 320 coupled with the first plate 310, a frame 330 including a separating structure 335 in the third region 300c separating the first flow path 301 and the second flow path 302, and a wick structure 340 for moving the fluid in the frame 330. The wick structure 340 may include a first wick portion 350 attached to the first plate 310, and a second wick portion 360 disposed in the second flow path 302 and at least partially interposed between the first wick portion 350 and the second plate 320.

According to an embodiment, the frame 330 may include another separating structure 710 spaced apart from the separating structure 335. The first flow path 301 and/or the second flow path 302 may be separated into a plurality of flow paths by the separating structure 335 and the another separating structure 710. The first wick portion 350 may include a slit 350a for passing the separating structure 335 and another slit 720 for passing the another separating structure 710.

For example, when referring to FIG. 7A, the first flow path 301 may include a first set of flow paths 301a and 301b separated from each other through the another separating structure 710 distinct from the separating structure 335. For example, when referring to FIG. 7B, the second flow path 302 for moving a fluid in a liquid state may be disposed between the first set of flow paths 301a and 301b for moving the fluid in a gaseous state, by the separating structure 335 and the another separating structure 710.

For example, when referring to FIG. 7C, the second flow path 302b may include a second set of flow paths 302a and 302b separated from each other by the separating structure 335 and the another separating structure 710. The first flow path 301 for moving the fluid in the gaseous state may be disposed between the second set of flow paths 302a and 302b for moving the fluid in the liquid state, by the separating structure 335 and the another separating structure 710. However, it is not limited thereto.

The frame 330 may include a plurality of separating structures including the separating structure 335 separating the first flow path 301 and the second flow path 302. The frame 330 may reduce damage to the third region 300c of the heat spreading member 300 in which the plurality of separating structures are disposed due to an external impact, by including the plurality of separating structures.

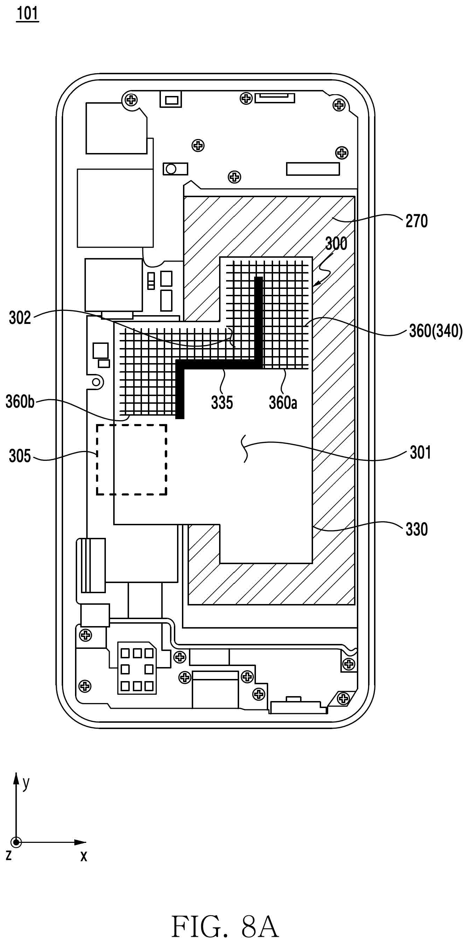

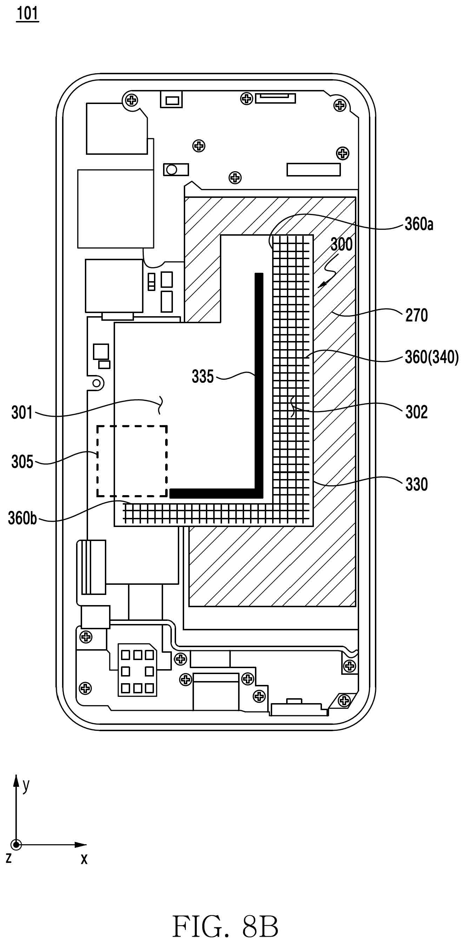

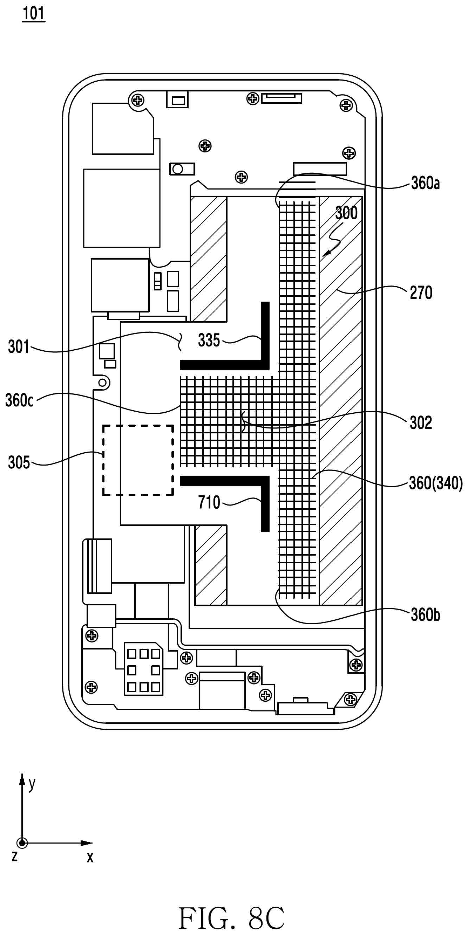

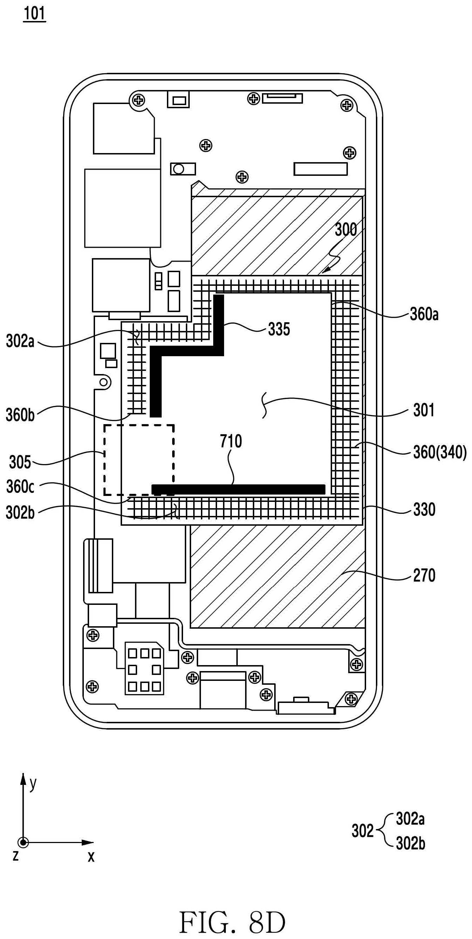

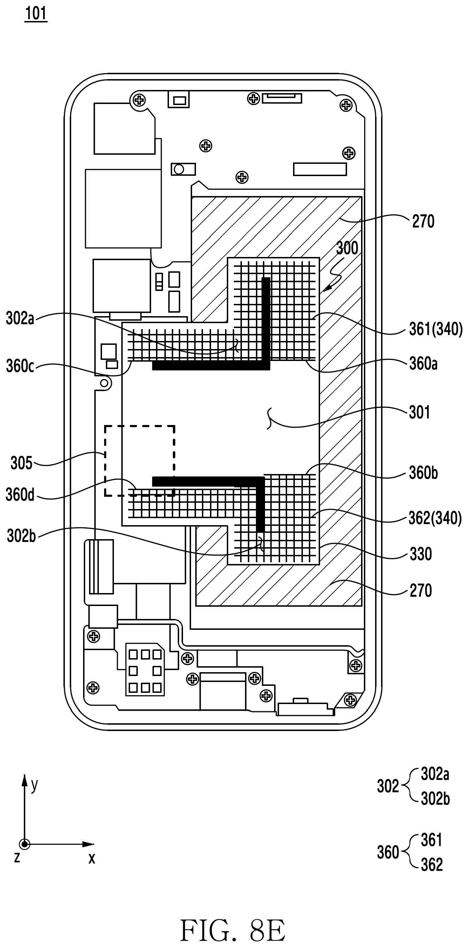

FIGS. 8A, 8B, 8C, 8D, and 8E illustrate a portion of an exemplary electronic device.

Referring to FIGS. 8A, 8B, 8C, 8D, and 8E, an electronic device 101 may include an electronic component 305 and a heat spreading member 300 at least partially disposed on the electronic component 305. The heat spreading member 300 may include a first flow path 301 for a fluid in a gaseous state, and a second flow path 302 for the fluid in a liquid state. The heat spreading member 300 may include a first plate (e.g., the first plate 310 of FIG. 3B), a second plate (e.g., the second plate 320 of FIG. 3B) coupled with the first plate 310, a frame 330 including a separating structure 335 separating the first flow path 301 and the second flow path 302, and a wick structure 340 for moving the fluid in the frame 330. The wick structure 340 may include a first wick portion (e.g., the first wick portion 350 of FIG. 3B) attached to the first plate 310, and a second wick portion 360 disposed in the second flow path 302 and at least partially interposed between the first wick portion 350 and the second plate 320.

According to an embodiment, the heat spreading member 300 may at least partially overlap the electronic component 305 when a display (e.g., the display 201 of FIG. 2A) is viewed from above (e.g., when viewed in a +z direction). For example, a portion of the heat spreading member 300 may overlap the electronic component 305 when the display 201 is viewed from above, and a remaining portion of the heat spreading member 300 may overlap a battery 270 in the electronic device 101. The wick structure 340 in the heat spreading member 300 may be configured to spread a fluid vaporized by heat generated from the electronic component 305 into the first flow path 301. The wick structure 340 may be configured to move a fluid liquefied in the first flow path 301 to a region (e.g., the first region 300a of FIG. 3A) adjacent to the electronic component 305 through the second flow path 302. The wick structure 340 (or the second wick portion 360 of the wick structure 340) may fill the second flow path 302.

Referring to FIGS. 8A and 8B, the separating structure 335 may separate the first flow path 301 and the second flow path 302. A fluid in the gaseous state evaporated by the electronic component 305 in the first flow path 301 may be spread into the first flow path 301. In the first flow path 301, a fluid adjacent to a first periphery part 360a of the second wick portion 360 spaced apart from the electronic component 305 when the display 201 is viewed from above (e.g., when viewed in the +z direction) may be liquefied. The liquefied fluid in a liquid state may be moved, through the wick structure 340 filling the second flow path 302, to a second periphery part 360b opposite to the first periphery part 360a of the second wick portion 360 and adjacent to the electronic component 305 when the display 201 is viewed from above. The fluid in the liquid state moved to the second periphery part 360b may be spread into the first flow path 301 by being vaporized by the electronic component 305.

Referring to FIGS. 8C, 8D, and 8E, the heat spreading member 300 may include separating structures 335 and 710 separating the first flow path 301 and the second flow path 302. The wick structure 340 may be configured to spread a fluid vaporized by the electronic component 305 into the first flow path 301. The wick structure 340 may be configured to move a fluid liquefied in the first flow path 301 to a region adjacent to the electronic component 305 through the second flow path 302.

For example, when referring to FIG. 8C, the separating structure 335 and another separating structure 710 may separate the first flow path 301 and the second flow path 302. In the first flow path 301, a fluid adjacent to the first periphery part 360a and the second periphery part 360b of the second wick portion 360 spaced apart from the electronic component 305 when the display 201 is viewed from above (e.g., when viewed in the +z direction) may be liquefied. The liquefied fluid in a liquid state may be moved, through the wick structure 340 filling the second flow path 302, to a third periphery part 360c spaced apart from the first periphery part 360a and the second periphery part 360b of the second wick portion 360 and adjacent to the electronic component 305 when the display 201 is viewed from above. The fluid in the liquid state moved to the third periphery part 360c may be spread into the first flow path 301 by being vaporized by the electronic component 305.

For example, when referring to FIG. 8D, the separating structure 335 and the another separating structure 710 may separate the first flow path 301 and a second set of flow paths 302a and 302b, respectively. In the first flow path 301, a fluid adjacent to the first periphery part 360a of the second wick portion 360 spaced apart from the electronic component 305 when the display 201 is viewed from above (e.g., when viewed in the +z direction) may be liquefied. The liquefied fluid in a liquid state may be moved, through the wick structure 340 filling the second set of flow paths 302a and 302b, to the second periphery part 360b and the third periphery part 360c spaced apart from the first periphery part 360a of the second wick portion 360 and adjacent to the electronic component 305 when the display 201 is viewed from above. The fluid in the liquid state moved to the second periphery part 360b and the third periphery part 360c may be spread into the first flow path 301 by being vaporized by the electronic component 305.

For example, when referring to FIG. 8E, the second wick portion 360 may include a first part 361 and a second part 362 spaced apart from each other. The separating structure 335 and the another separating structure 710 may separate the first flow path 301 and the second set of flow paths 302a and 302b, respectively. In the first flow path 301, a fluid adjacent to the first periphery part 360a of the first part 361 and the second periphery part 360b of the second part 362 spaced apart from the electronic component 305 when the display 201 is viewed from above (e.g., when viewed in the +z direction) may be liquefied. The liquefied fluid in a liquid state may be moved, through the wick structure 340 filling the second set of flow paths 302a and 302b, to the third periphery part 360c and a fourth periphery part 360d spaced apart from the first periphery part 360a and the second periphery part 360b of the second wick portion 360 and adjacent to the electronic component 305 when the display 201 is viewed from above. The fluid in the liquid state moved to the third periphery part 360c and the fourth periphery part 360d may be spread into the first flow path 301 by being vaporized by the electronic component 305.

According to the above-described embodiment, the heat spreading member 300 of the electronic device 101 may reduce damage to the electronic device 101 by heat generated from the electronic component 305, by including the wick structure 340 disposed in the heat spreading member 300 in various forms.

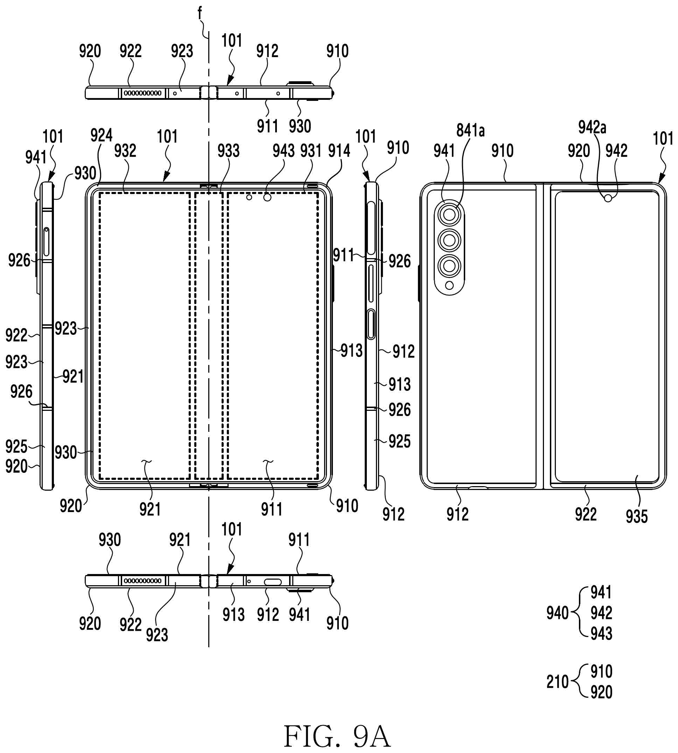

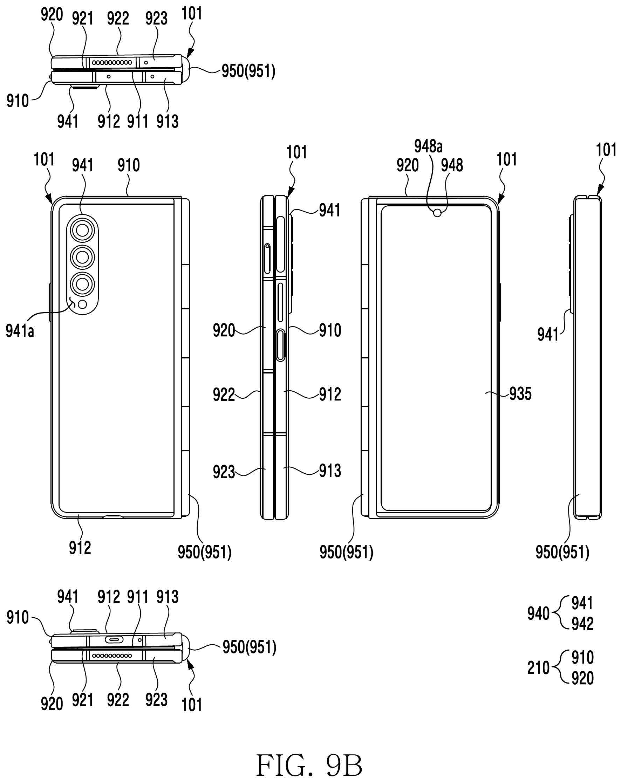

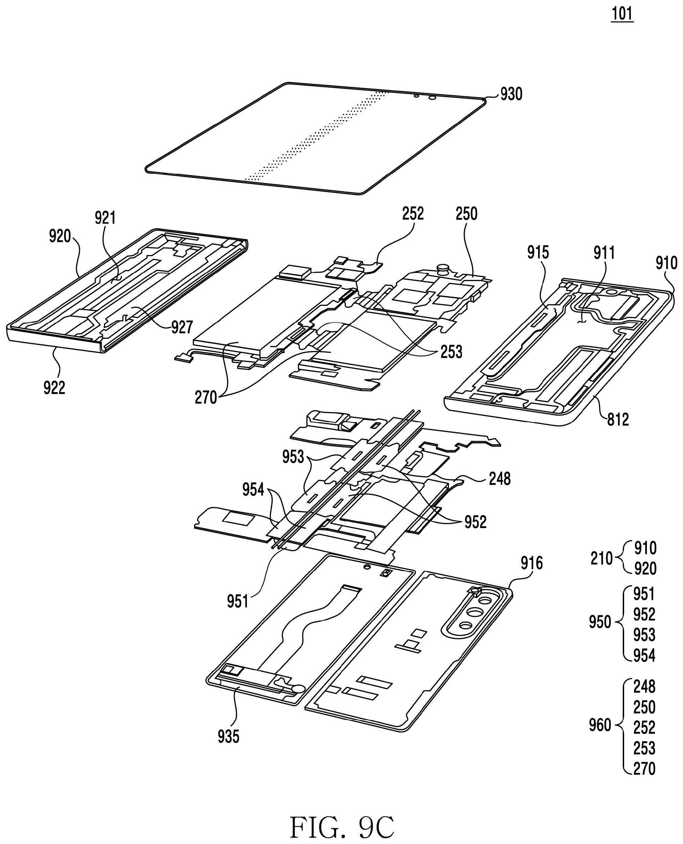

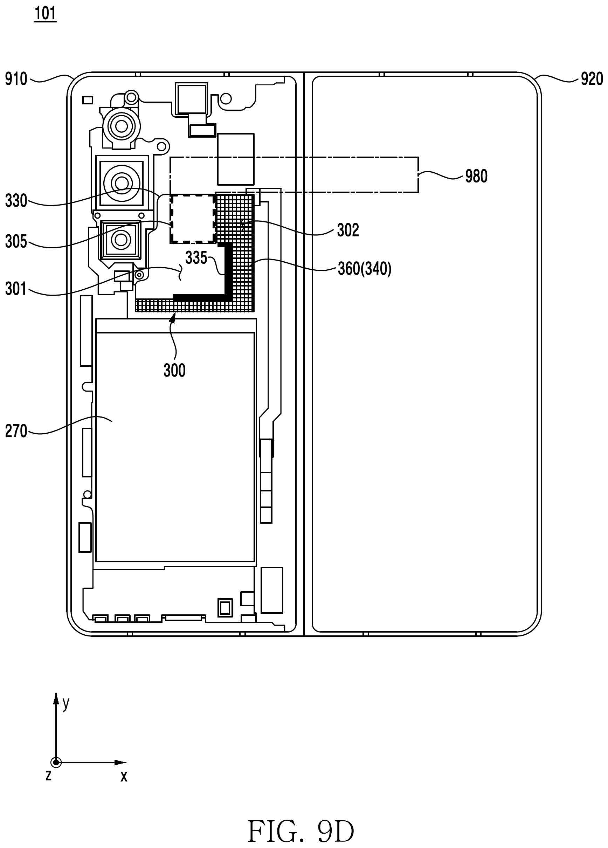

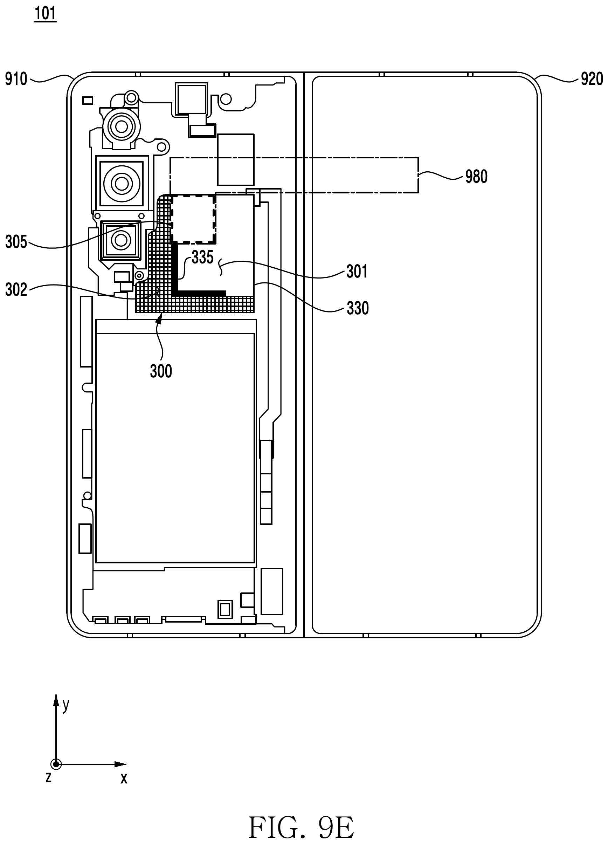

FIG. 9A illustrates an unfolded state of an exemplary electronic device. FIG. 9B illustrates a folded state of an exemplary electronic device. FIG. 9C is an exploded view of an exemplary electronic device. FIGS. 9D and 9E illustrate a portion of an exemplary electronic device.

Referring to FIGS. 9A, 9B, and 9C, an electronic device 101 (e.g., the electronic device 101 of FIG. 1) may include a housing 210 including a first housing 910 and a second housing 920, a flexible display 930 (e.g., the display module 160 of FIG. 1 or the display 201 of FIG. 2A), at least one camera 940 (e.g., the camera module 180 of FIG. 1), a hinge structure 950, and/or at least one electronic component 960.

The first housing 910 and the second housing 920 may form at least a portion of an outer surface of the electronic device 101 that may be gripped by a user. The at least a portion of the outer surface of the electronic device 101 defined by the first housing 910 and the second housing 920 may contact a part of the user's body when the electronic device 101 is used by the user. According to an embodiment, the first housing 910 may include a first surface 911, a second surface 912 facing the first surface 911 and spaced apart from the first surface 911, and a third lateral surface 913 surrounding at least a portion of the first surface 911 and the second surface 912. The third lateral surface 913 may connect a periphery of the first surface 911 and a periphery of the second surface 912. The first surface 911, the second surface 912, and the third lateral surface 913 may define an internal space of the first housing 910. According to an embodiment, the first housing 910 may provide a space formed by the first surface 911, the second surface 912, and the third lateral surface 913 as a space for disposing components of the electronic device 101.

According to an embodiment, the second housing 920 may include a third surface 921, a fourth surface 922 facing the third surface 921 and spaced apart from the third surface 921, and a fourth lateral surface 923 surrounding at least a portion of the third surface 921 and the fourth surface 922. The fourth lateral surface 923 may connect a periphery of the third surface 921 and a periphery of the fourth surface 922. The third surface 921, the fourth surface 922, and the fourth lateral surface 923 may define an internal space of the second housing 920. According to an embodiment, the second housing 920 may provide a space formed by the third surface 921, the fourth surface 922, and the fourth lateral surface 923 surrounding at least a portion of the third surface 921 and the fourth surface 922 as a space for mounting components of the electronic device 101. According to an embodiment, the second housing 920 may be coupled with the first housing 910 to be rotatable with respect to the first housing 910.

According to an embodiment, each of the first housing 910 and the second housing 920 may include a first protective member 914 and a second protective member 924, respectively. The first protective member 914 and the second protective member 924 may be disposed on the first surface 911 and the third surface 921 along a periphery of the flexible display 930. According to an embodiment, the first protective member 914 and the second protective member 924 may prevent introduction of a foreign substance (e.g., dust or moisture) through a gap between the flexible display 930 and the first housing 910 and the second housing 920. For example, the first protective member 914 may surround a periphery of a first display region 931 of the flexible display 930, and the second protective member 924 may surround a periphery of a second display region 932 of the flexible display 930. The first protective member 914 may be formed by being attached to the third lateral surface 913 of the first housing 910, or may be formed integrally with the third lateral surface 913. The second protective member 924 may be formed by being attached to the fourth lateral surface 923 of the second housing 920, or may be formed integrally with the fourth lateral surface 923.

According to an embodiment, the third lateral surface 913 and the fourth lateral surface 923 may include a conductive material, a non-conductive material, or a combination thereof. For example, the fourth lateral surface 923 may include at least one conductive member 925 and at least one non-conductive member 926. The at least one conductive member 925 may include a plurality of conductive members each spaced apart from each other. The at least one non-conductive member 926 may be disposed between the plurality of conductive members. The plurality of conductive members may be disconnected from each other by the at least one non-conductive member 926 disposed between the plurality of conductive members. According to an embodiment, the plurality of conductive members and a plurality of non-conductive members may form an antenna radiator together. The electronic device 101 may communicate with an external electronic device through the antenna radiator formed by the plurality of conductive members and the plurality of non-conductive members.

The flexible display 930 may be configured to display visual information. According to an embodiment, the flexible display 930 may be disposed, across the hinge structure 950, on the first surface 911 of the first housing 910 and the third surface 921 of the second housing 920. For example, the flexible display 930 may include the first display region 931 disposed on the first surface 911 of the first housing, the second display region 932 disposed on the third surface 921 of the second housing, and a third display region 933 disposed between the first display region 931 and the second display region 932. The first display region 931, the second display region 932, and the third display region 933 may form a front surface of the flexible display 930. According to an embodiment, the flexible display 930 may further include a sub-display panel 935 disposed on the fourth surface 922 of the second housing 920. According to an embodiment, the flexible display 930 may include a window exposed toward the outside of the electronic device 101. The window may protect a surface of the flexible display 930 and transmit visual information provided by the flexible display 930 to the outside of the electronic device 101 by including a substantially transparent material. For example, the window may include glass (e.g., ultra-thin glass (UTG)) and/or polymer (e.g., polyimide (PI)), but is not limited thereto.

The at least one camera 940 may be configured to obtain an image based on receiving light from a subject outside the electronic device 101. According to an embodiment, the at least one camera 940 may include third cameras 941 (e.g., the rear camera 212 of FIG. 2A), a fourth camera 942, and a fifth camera 943. The third cameras 941 may be disposed in the first housing 910. For example, the third cameras 941 may be disposed inside the first housing 910, and at least a portion thereof may be visible through the second surface 912 of the first housing 910. The third cameras 941 may be supported by a bracket (not illustrated) in the first housing 910. The first housing 910 may include at least one opening 941a overlapping the third cameras 941 when the electronic device 101 is viewed from above. The third cameras 941 may obtain an image based on receiving light from the outside of the electronic device 101 through the at least one opening 941a.

According to an embodiment, the fourth camera 942 may be disposed in the second housing 920. For example, the fourth camera 942 may be disposed inside the second housing 920 and may be visible through the sub-display panel 935. The second housing 920 may include at least one opening 942a overlapping the fourth camera 942 when the electronic device 101 is viewed from above. The fourth camera 942 may obtain an image based on receiving light from the outside of the electronic device 101 through the at least one opening 942a.

According to an embodiment, the fifth camera 943 may be disposed in the first housing 910. For example, the fifth camera 943 may be disposed inside the first housing 910, and at least a portion thereof may be visible through the first surface 911 of the first housing 910. For another example, the fifth camera 943 may be disposed inside the first housing 910, and at least a portion thereof may be visible through the first display region 931 of the flexible display 930. The first display region 931 of the flexible display 930 may include at least one opening overlapping the fifth camera 943 when the flexible display 930 is viewed from above. The fifth camera 943 may obtain an image based on receiving light from the outside of the flexible display 930 through the at least one opening.

According to an embodiment, the fourth camera 942 and the fifth camera 943 may be disposed below the flexible display 930 (e.g., in a direction toward the inside of the first housing 910 or the inside of the second housing 920). For example, the fourth camera 942 and the fifth camera 943 may be under display cameras (UDCs). In a case that the fourth camera 942 and the fifth camera 943 are the under display cameras, a region of the flexible display 930 corresponding to a location of each of the fourth camera 942 and the fifth camera 943 may not be an inactive region. The inactive region of the flexible display 930 may mean a region of the flexible display 930 that does not include a pixel or does not emit light to the outside of the electronic device 101. For another example, the fourth camera 942 and the fifth camera 943 may be punch hole cameras. In a case that the fourth camera 942 and the fifth camera 943 are the punch hole cameras, a region of the flexible display 930 corresponding to a location of each of the fourth camera 942 and the fifth camera 943 may be an inactive region.

According to an embodiment, the hinge structure 950 may rotatably connect the first housing 910 and the second housing 920. The hinge structure 950 may be disposed between the first housing 910 and the second housing 920 of the electronic device 101 so that the electronic device 101 may be bent, curved, or folded. For example, the hinge structure 950 may be disposed between a portion of the third lateral surface 913 and a portion of the fourth lateral surface 923 that face each other. The hinge structure 950 may change the electronic device 101 into an unfolded state in which the first surface 911 of the first housing 910 and the third surface 921 of the second housing 920 face in the same direction or a folded state in which the first surface 911 and the third surface 921 face each other. When the electronic device 101 is in the folded state, the first housing 910 and the second housing 920 may be stacked or overlapped by facing each other.

According to an embodiment, when the electronic device 101 is in the folded state, a direction in which the first surface 911 faces and a direction in which the third surface 921 faces may be different from each other. For example, when the electronic device 101 is in the folded state, the direction in which the first surface 911 faces and the direction in which the third surface 921 faces may be opposite to each other. For another example, when the electronic device 101 is in the folded state, the direction in which the first surface 911 faces and the direction in which the third surface 921 faces may be inclined with respect to each other. In a case that the direction in which the first surface 911 faces is inclined with respect to the direction in which the third surface 921 faces, the first housing 910 may be inclined with respect to the second housing 920.

According to an embodiment, the electronic device 101 may be foldable with respect to a folding axis f. The folding axis f may mean an imaginary line extending through the hinge cover 951 in a direction parallel to a longitudinal direction of the electronic device 101, but is not limited thereto. For example, the folding axis f may be an imaginary line extending in a direction perpendicular to the longitudinal direction of the electronic device 101. In a case that the folding axis f extends in the direction perpendicular to the longitudinal direction of the electronic device 101, the hinge structure 950 may connect the first housing 910 and the second housing 920 by extending in a direction parallel to the folding axis f. The first housing 910 and the second housing 920 may be rotatable by the hinge structure 950 extending in the direction perpendicular to the longitudinal direction of the electronic device 101.

According to an embodiment, the hinge structure 950 may include a hinge cover 951, a first hinge plate 952, a second hinge plate 953, and a hinge module 954. The hinge cover 951 may surround internal components of the hinge structure 950 and form an outer surface of the hinge structure 950. According to an embodiment, when the electronic device 101 is in the folded state, at least a portion of the hinge cover 951 surrounding the hinge structure 950 may be exposed to the outside of the electronic device 101 through a space between the first housing 910 and the second housing 920. According to an embodiment, when the electronic device 101 is in the unfolded state, the hinge cover 951 may be covered by the first housing 910 and the second housing 920 and may not be exposed to the outside of the electronic device 101.

According to an embodiment, the first hinge plate 952 and the second hinge plate 953 may rotatably connect the first housing 910 and the second housing 920 by being coupled with the first housing 910 and the second housing 920, respectively. For example, the first hinge plate 952 may be coupled with a first front bracket 915 of the first housing 910, and the second hinge plate 953 may be coupled with a second front bracket 927 of the second housing 920. As the first hinge plate 952 and the second hinge plate 953 are coupled with the first front bracket 915 and the second front bracket 927, respectively, the first housing 910 and the second housing 920 may be rotatable according to rotation of the first hinge plate 952 and the second hinge plate 953.

The hinge module 954 may rotate the first hinge plate 952 and the second hinge plate 953. For example, the hinge module 954 may rotate the first hinge plate 952 and the second hinge plate 953 based on the folding axis f by including gears engaged with each other to be rotatable. According to an embodiment, there may be a plurality of hinge modules 954. For example, the plurality of hinge modules 954 may be spaced apart from each other and disposed at both ends of the first hinge plate 952 and the second hinge plate 953, respectively.

According to an embodiment, the first housing 910 may include the first front bracket 915 and a rear bracket 916, and the second housing 920 may include the second front bracket 927. The first front bracket 915 and the rear bracket 916 may be disposed inside the first housing 910 and may support components of the electronic device 101. The second front bracket 927 may be disposed inside the second housing 920 and may support components of the electronic device 101. For example, the flexible display 930 may be disposed on a surface of the first front bracket 915 and a surface of the second front bracket 927. The rear bracket 916 may be disposed on another surface of the first front bracket 915 facing the surface of the first front bracket 915.

According to an embodiment, a portion of the first front bracket 915 may be surrounded by the third lateral surface 913, and a portion of the second front bracket 927 may be surrounded by the fourth lateral surface 923. For example, the first front bracket 915 may be integrally formed with the third lateral surface 913, and the second front bracket 927 may be integrally formed with the fourth lateral surface 923. For another example, the first front bracket 915 may be formed separately from the third lateral surface 913, and the second front bracket 927 may be formed separately from the fourth lateral surface 923.

The at least one electronic component 960 may implement various functions to be provided to the user. According to an embodiment, the at least one electronic component 960 may include a first printed circuit board 250, a second printed circuit board 252, a flexible printed circuit board 253, a battery 270 (e.g., the battery 189 of FIG. 1), and/or an antenna 248 (e.g., the antenna module 197 of FIG. 1). The first printed circuit board 250 and the second printed circuit board 252 may each form an electrical connection between components in the electronic device 101. For example, components (e.g., the processor 120 of FIG. 1) for implementing overall functions of the electronic device 101 may be disposed on the first printed circuit board 250, and electronic components for implementing some functions of the first printed circuit board 250 may be disposed on the second printed circuit board 252. For another example, components for an operation of the sub-display panel 935 disposed on the fourth surface 922 may be disposed on the second printed circuit board 252.

According to an embodiment, the first printed circuit board 250 may be disposed in the first housing 910. For example, the first printed circuit board 250 may be disposed on a surface of the first front bracket 915. According to an embodiment, the second printed circuit board 252 may be disposed in the second housing 920. For example, the second printed circuit board 252 may be spaced apart from the first printed circuit board 250 and disposed on a surface of the second front bracket 927. The flexible printed circuit board 253 may connect the first printed circuit board 250 and the second printed circuit board 252. For example, the flexible printed circuit board 253 may extend from the first printed circuit board 250 to the second printed circuit board 252.

The battery 270 is a device for supplying power to at least one component of the electronic device 101, and may include, for example, a non-rechargeable primary battery, a rechargeable secondary battery, or a fuel cell. At least a portion of the battery 270 may be disposed on substantially the same plane as the first printed circuit board 250 or the second printed circuit board 252.

The antenna 248 may be configured to receive power or a signal from the outside of the electronic device 101. According to an embodiment, the antenna 248 may be disposed between the rear bracket 916 and the battery 270. The antenna 248 may include, for example, a near field communication (NFC) antenna, an antenna module, and/or a magnetic secure transmission (MST) antenna. The antenna 248 may, for example, perform short-range communication with an external device or wirelessly transmit and receive power required for charging.

Referring to FIGS. 9D and 9E, the electronic device 101 may include the first housing 910, the second housing 920, the hinge structure 950, an electronic component 305, and a heat spreading member 300 at least partially disposed on the electronic component 305. The heat spreading member 300 may include a first flow path 301 for a fluid in a gaseous state, and a second flow path 302 for the fluid in a liquid state. The heat spreading member 300 may include a first plate (e.g., the first plate 310 of FIG. 3B), a second plate (e.g., the second plate 320 of FIG. 3B) coupled with the first plate 310, a frame 330 including a separating structure 335 separating the first flow path 301 and the second flow path 302, and a wick structure 340 for moving the fluid in the frame 330. The wick structure 340 may include a first wick portion (e.g., the first wick portion 350 of FIG. 3B) attached to the first plate 310, and a second wick portion 360 disposed in the second flow path 302 and at least partially interposed between the first wick portion 350 and the second plate 320.

According to an embodiment, the first housing 910 may accommodate the heat spreading member 300. The second housing 920 may be rotatably coupled to the first housing 910. The hinge structure (e.g., the hinge structure 950 of FIG. 9B) may connect the first housing 910 and the second housing 920.

For example, the electronic component 305 may be disposed in the first housing 910. The heat spreading member 300 may be disposed in the first housing 910 to at least partially overlap the electronic component 305 when the flexible display (e.g., the flexible display 930 of FIG. 9A) is viewed from above.

For example, the separating structure 335 in the heat spreading member 300 may separate the first flow path 301 and the second flow path 302. A fluid in the gaseous state evaporated by the electronic component 305 in the first flow path 301 may be spread into the first flow path 301. In the first flow path 301, a fluid adjacent to a first periphery part 360a of the second wick portion 360 spaced apart from the electronic component 305 when the flexible display 930 is viewed from above (e.g., when viewed in a +z direction) may be liquefied. The liquefied fluid in a liquid state may be moved, through the wick structure 340 filling the second flow path 302, to a second periphery part 360b opposite to the first periphery part 360a of the second wick portion 360 and adjacent to the electronic component 305 when the flexible display 930 is viewed from above. The fluid in the liquid state moved to the second periphery part 360b may be spread into the first flow path 301 by being vaporized by the electronic component 305. The heat spreading member 300 may reduce, by dissipating heat generated from the electronic component 305, damage to electronic components disposed in the first housing 910 due to the heat.

According to an embodiment, the electronic device 101 may include a heat transfer member 980 extending, across the hinge structure 950, from the first housing 910 toward the second housing 920. The heat spreading member 300 may be configured such that the first flow path 301 is located closer to the heat transfer member 980 than the second flow path 302.

For example, the heat transfer member 980 may at least partially overlap the electronic component 305 when the flexible display 930 is viewed from above (e.g., when viewed in the +z direction). For example, the heat transfer member 980 may be attached on a region (e.g., the first region 300a of FIG. 3A) in which the first flow path 301 among the first flow path 301 and the second flow path 302 of the heat spreading member 300 is disposed. According to an embodiment, the heat spreading member 300 may be located between the electronic component 305 and the heat transfer member 980. The region of the heat spreading member 300 in which the heat transfer member 980 is disposed may be a region disposed on the electronic component 305. For example, the heat transfer member 980 may extend from the region of the heat spreading member 300 in which the first flow path 301 is disposed, across the hinge structure 950, to the second housing 920. Heat transferred from the electronic component 305 to the heat transfer member 980 through the first flow path 301 may be dissipated from the first housing 910 to the second housing 920 through the heat transfer member 980. The heat transfer member 980 may reduce damage to the electronic device 101 due to heat generated from the electronic component 305 and may dissipate, through the second housing 920, heat transferred from the electronic component 305 to the heat spreading member 300, by providing a heat transfer path for transferring the heat transferred from the electronic component 305 to the heat spreading member 300 from the first housing 910 to the second housing 920.

According to the above-described embodiment, the electronic device 101 may reduce damage to the electronic device 101 due to heat by including the heat transfer member 980 configured to transfer the heat generated from the electronic component 305 in the first housing 910 to the second housing 920 rotatably coupled to the first housing 910.

According to the above-described embodiment, an electronic device (e.g., the electronic device 101 of FIG. 1) may comprise an electronic component (e.g., the electronic component 305 of FIG. 3A), and a heat spreading member (e.g., the heat spreading member 300 of FIG. 3A) at least partially disposed on the electronic component. The heat spreading member may include a first region (e.g., the first region 300a of FIG. 3A) facing the electronic component, a second region (e.g., the second region 300b of FIG. 3A) spaced apart from the first region, and a third region (e.g., the third region 300c of FIG. 3A) connecting the first region and the second region, and including a first flow path (e.g., the first flow path 301 of FIG. 3A) for a fluid in a gaseous state and a second flow path (e.g., the second flow path 302 of FIG. 3A) for the fluid in a liquid state. The heat spreading member may include a first plate (e.g., the first plate 310 of FIG. 3B), a second plate (e.g., the second plate 320 of FIG. 3B) coupled with the first plate, and a frame (e.g., the frame 330 of FIG. 3B) including a separating structure (e.g., the separating structure 335 of FIG. 3A) in the third region separating the first flow path and the second flow path. The heat spreading member may include a wick structure (e.g., the wick structure 340 of FIG. 3B) for moving the fluid in the frame. The wick structure may include a first wick portion (e.g., the first wick portion 350 of FIG. 3B) attached to the first plate, and a second wick portion (e.g., the second wick portion 360 of FIG. 3B) disposed in the second flow path and at least partially interposed between the first wick portion and the second plate. According to the above-mentioned embodiment, the heat spreading member 300 may reduce damage to the electronic device due to heat by dissipating the heat emitted from the electronic component 305. The heat spreading member 300 may improve performance of the heat spreading member by including the separating structure separating the first flow path and the second flow path. The wick structure may improve the performance of the heat spreading member by including the second wick portion at least partially disposed in the second flow path. The above-mentioned embodiment may have various effects including the above-mentioned effect.

According to an embodiment, the first wick portion may include a slit (e.g., the slit 350a of FIG. 3B) for passing the separating structure. According to the above-mentioned embodiment, the first wick portion may provide a space for the separating structure by including the slit. The above-mentioned embodiment may have various effects including the above-mentioned effect.

According to an embodiment, the frame may further include first pillars (e.g., the first pillars 410 of FIG. 4A) protruding from the second plate toward the first plate in the first flow path and contacting the first plate. According to the above-mentioned embodiment, the frame may reduce damage to the first flow path due to the external impact by including the first pillars. The above-mentioned embodiment may have various effects including the above-mentioned effect.

According to an embodiment, the second wick portion may fill the second flow path together with the first wick portion. According to the above-mentioned embodiment, the second wick portion may improve the performance of the heat spreading member by filling the second flow path together with the first wick portion. The above-mentioned embodiment may have various effects including the above-mentioned effect.

According to an embodiment, the first wick portion may include a first portion (e.g., the first portion 351 of FIG. 3B) disposed in the first region, a second portion (e.g., the second portion 352 of FIG. 3B) disposed in the second region, and a third portion (e.g., the third portion 353 of FIG. 3B), disposed in the third region, connecting the first portion and the second portion including a first supporting region (e.g., the first supporting region 353a of FIG. 3B) disposed in the first flow path and a second supporting region (e.g., the second supporting region 353b of FIG. 3B) disposed in the second flow path to support the second plate. According to the above-mentioned embodiment, the first wick portion may improve the performance of the heat spreading member by including the first supporting region and the second supporting region. The above-mentioned embodiment may have various effects including the above-mentioned effect.

According to an embodiment, the frame may further include first pillars protruding from the second plate toward the first plate in the first flow path and contacting the first supporting region. According to the above-mentioned embodiment, the frame may reduce damage to the first flow path due to an external impact by including the first pillars contacting the first supporting region. The above-mentioned embodiment may have various effects including the above-mentioned effect.

According to an embodiment, the frame may further include second pillars (e.g., the second pillars 420 of FIG. 4B) protruding from the second plate toward the first plate in the second flow path and contacting the second supporting region. The second wick portion may include a plurality of through holes (e.g., the plurality of through holes 430 of FIG. 4B) for passing the second pillars in the second flow path. According to the above-mentioned embodiment, the frame may reduce damage to the second flow path due to an external impact by including the second pillars. The above-mentioned embodiment may have various effects including the above-mentioned effect.

According to an embodiment, the third region may be configured to move the fluid in a gaseous state from the first region to the third region through the first flow path and move the fluid in a liquid state from the second region to the first region through the second flow path. According to the above-mentioned embodiment, the third region may improve the performance of the heat spreading member by being configured to circulate the fluid in the heat spreading member. The above-mentioned embodiment may have various effects including the above-mentioned effect.

According to an embodiment, the separating structure may have a curvature by being at least partially bent. According to the above-mentioned embodiment, the separating structure may be configured such that the heat spreading member is disposed in the electronic device, by being at least partially bent. The above-mentioned embodiment may have various effects including the above-mentioned effect.

According to an embodiment, the separating structure may contact the second plate by extending from the first plate toward the second plate in the third region. According to the above-mentioned embodiment, the heat spreading member may improve the performance of the heat spreading member and reduce damage to the third region due to an external impact, by including the separating structure. The above-mentioned embodiment may have various effects including the above-mentioned effect.

According to an embodiment, the separating structure may contact the first plate by extending from the second plate toward the first plate in the third region. According to the above-mentioned embodiment, the heat spreading member may improve the performance of the heat spreading member and reduce damage to the third region due to an external impact, by including the separating structure. The above-mentioned embodiment may have various effects including the above-mentioned effect.

According to an embodiment, the separating structure may include a first protrusion (e.g., the first protrusion 610 of FIG. 6C) extending from the first plate toward the second plate in the third region, a second protrusion (e.g., the second protrusion 620 of FIG. 6C) facing the first protrusion by extending from the second plate toward the first plate in the third region, and an adhesive member (e.g., the adhesive member 650 of FIG. 6C) connecting the first protrusion and the second protrusion. According to the above-mentioned embodiment, the heat spreading member may improve the performance of the heat spreading member and reduce damage to the third region due to an external impact, by including the separating structure. The above-mentioned embodiment may have various effects including the above-mentioned effect.

According to an embodiment, the separating structure may include a first supporting portion (e.g., the first supporting portion 335a of FIG. 6D) protruding from the second plate toward the first wick portion, and a second supporting portion (e.g., the second supporting portion 335b of FIG. 6D) that is connected to the first supporting portion and at least partially fills the first wick portion. According to the above-mentioned embodiment, the heat spreading member may improve the performance of the heat spreading member and reduce damage to the third region due to an external impact, by including the separating structure. The above-mentioned embodiment may have various effects including the above-mentioned effect.

According to an embodiment, the frame may further include at least one recess (e.g., the at least one recess 630 of FIG. 6A) formed in the separating structure. According to the above-mentioned embodiment, the heat spreading member may improve the performance of the heat spreading member and reduce damage to the third region due to an external impact, by including the separating structure including the at least one recess. The above-mentioned embodiment may have various effects including the above-mentioned effect.

According to an embodiment, the wick structure may include at least one of a mesh wick and a sintering wick. According to the above-mentioned embodiment, the wick structure may improve the performance of the heat spreading member by including at least one of the mesh wick and the sintering wick. The above-mentioned embodiment may have various effects including the above-mentioned effect.

According to an embodiment, an electronic device may comprise an electronic component, and a heat spreading member disposed at least partially on the electronic component. The heat spreading member may include a first region facing the electronic component, a second region spaced apart from the first region, and a third region connecting the first region and the second region, and including a first flow path and a second flow path, the first flow path being for a fluid in a gaseous state, and the second flow path being for the fluid in a liquid state. The heat spreading member may include a frame including a separating structure in the third region separating the first flow path and the second flow path, and a wick structure for moving the fluid in the frame. The wick structure may include a first wick portion including a first portion disposed in the first region, a second portion disposed in the second region, and a third portion disposed in the third region and connecting the first portion and the second portion, and a second wick portion disposed in the second flow path and at least partially interposed between the third portion and the frame. According to the above-mentioned embodiment, the heat spreading member 300 may reduce damage to the electronic device due to heat by dissipating the heat emitted from the electronic component 305. The heat spreading member 300 may improve performance of the heat spreading member by including the separating structure separating the first flow path and the second flow path. The wick structure may improve the performance of the heat spreading member by including the second wick portion at least partially disposed in the second flow path. The above-mentioned embodiment may have various effects including the above-mentioned effect.

According to an embodiment, the second wick portion may fill the second flow path together with the first wick portion. According to the above-mentioned embodiment, the second wick portion may improve the performance of the heat spreading member by filling the second flow path together with the first wick portion. The above-mentioned embodiment may have various effects including the above-mentioned effect.

According to an embodiment, the third portion may include a first supporting region disposed in the first flow path, and a second supporting region disposed in the second flow path. The frame may further include a first plate on which the first wick portion is attached, a second plate, on which the second wick portion is attached, coupled with the first plate, and first pillars protruding from the second plate toward the first plate in the first flow path and contacting the first supporting region. According to the above-mentioned embodiment, the frame may reduce damage to the first flow path due to an external impact by including the first pillars contacting the first supporting region. The above-mentioned embodiment may have various effects including the above-mentioned effect.

According to an embodiment, the frame may further include second pillars protruding from the second plate toward the first plate in the second flow path and contacting the second supporting region. The second wick portion may include a plurality of through holes for passing the second pillars in the second flow path. According to the above-mentioned embodiment, the frame may reduce damage to the second flow path due to an external impact by including the second pillars. The above-mentioned embodiment may have various effects including the above-mentioned effect.

According to an embodiment, the third region may be configured to move the fluid in a gaseous state from the first region to the third region through the first flow path and move the fluid in a liquid state from the second region to the first region through the second flow path. According to the above-mentioned embodiment, the third region may improve the performance of the heat spreading member by being configured to circulate the fluid in the heat spreading member. The above-mentioned embodiment may have various effects including the above-mentioned effect.

According to an embodiment, an electronic device (e.g., the electronic device 101 of FIG. 1) may comprise a display (e.g., the display 201 of FIG. 2A or the flexible display 930 of FIG. 9A), an electronic component (e.g., the electronic component 305 of FIG. 3A), and a heat spreading member (e.g., the heat spreading member 300 of FIG. 3A) disposed to at least partially overlap the electronic component when viewed from above the display. The heat spreading member may include a first plate (e.g., the first plate 310 of FIG. 3B) facing the electronic component, a second plate (e.g., the second plate 320 of FIG. 3B) substantially facing the first plate, and a separating structure (e.g., the separating structure 335 of FIG. 3A) disposed in an internal space between the first plate and the second plate such that a first flow path (e.g., the first flow path 301 of FIG. 3A) and a second flow path (e.g., the second flow path 302 of FIG. 3A) are respectively formed along a first lateral surface (e.g., the first lateral surface 330a of FIG. 3A) and a second lateral surface (e.g., the second lateral surface 330b of FIG. 3A) opposite to the first lateral surface thereof. The heat spreading member may include a wick structure (e.g., the wick structure 340 of FIG. 3B) for moving a fluid along at least one of the first flow path and the second flow path. The wick structure may include a first wick portion (e.g., the first wick portion 350 of FIG. 3B) located in the first flow path and the second flow path, and a second wick portion (e.g., the second wick portion 360 of FIG. 3B) located over a portion corresponding to the second flow path among the first wick portion.

According to an embodiment, the first flow path may be configured to spread the fluid substantially vaporized by heat generated from the electronic component from a first region (e.g., the first region 300a of FIG. 3A) of the heat spreading member through the first flow path to a second region (e.g., the second region 300b of FIG. 3A) opposite to the first region. The second flow path may be configured to spread the fluid substantially liquefied in the second region from the second region through the second flow path to the first region.

According to an embodiment, the first wick portion may be attached on the first plate. The second wick portion may be attached on the first wick portion.

According to an embodiment, the separating structure may include a protrusion (e.g., the first protrusion 610 or the second protrusion 620 of FIG. 6C) protruding from one of the first plate and the second plate.

According to an embodiment, the protrusion may be formed to contact other one among the first plate and the second plate.

According to an embodiment, the protrusion may be welded to the first wick portion.

According to an embodiment, the first wick portion may include a slit (e.g., the slit 350a of FIG. 3B) corresponding to the separating structure.

According to an embodiment, the heat spreading member may further include first pillars (e.g., the first pillars 410 of FIG. 4A), protruding from the second plate toward the first plate within the first flow path and contacting the first wick portion.

According to an embodiment, the first wick portion may include a plurality of holes (e.g., the plurality of holes 440 of FIG. 4C) corresponding to at least a portion of a space between the first pillars.

According to an embodiment, the second plate may include a plurality of recesses formed along the separating structure within the second flow path. The second wick portion may be configured to fill the recesses.

According to an embodiment, the wick structure may include a separating portion (e.g., the separating portion 340b of FIG. 5D) in which pores are not formed, as at least a portion of the separating structure.

According to an embodiment, the electronic device 101 may comprise a first housing (e.g., the first housing 910 of FIG. 9A) accommodating the heat spreading member, a second housing rotatably coupled with the first housing, a hinge structure (e.g., the hinge structure 950 of FIG. 9B) connecting the first housing and the second housing, and a heat transfer member (e.g., the heat transfer member 980 of FIG. 9D) extending from the first housing across the hinge structure to the second housing. The heat spreading member may be configured such that the first flow path is located closer to the heat transfer member than the second flow path.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (101) comprising:
a display (201);
an electronic component (305); and
a heat spreading member (300) disposed to at least partially overlap the electronic component (305) when viewed from above the display (201);
wherein the heat spreading member (300) includes:
a first plate (310) facing the electronic component (305);
a second plate (320) substantially facing the first plate (310);
a separating structure (335) disposed in an internal space between the first plate (310) and the second plate (320) such that a first flow path (301) and a second flow path (302) are respectively formed along a first lateral surface (330a) and a second lateral surface (330b) opposite to the first lateral surface (330a) thereof; and,
a wick structure (340) for moving a fluid along at least one of the first flow path (301) or the second flow path (302); and
wherein the wick structure (340) includes:
a first wick portion (350) located in the first flow path (301) and the second flow path (302); and
a second wick portion (360) located over a portion of the first wick portion (350) corresponding to the second flow path (302).

2. The electronic device (101) of claim 1,
wherein the first flow path (301) is configured to spread the fluid substantially vaporized by heat generated from the electronic component (305) from a first region (300a) of the heat spreading member (300) through the first flow path (301) to a second region (300b) opposite to the first region (300a), and
wherein the second flow path (302) is configured to spread the fluid substantially liquefied in the second region (300b) from the second region (300b) through the second flow path (302) to the first region (300a).

3. The electronic device (101) of claim 1 or 2,
wherein the first wick portion (350) is attached to the first plate (310), and
wherein the second wick portion (360) is attached to the first wick portion (350).

4. The electronic device (101) of any one of claims 1 to 3,
wherein the separating structure (335) includes a protrusion (610, 620) protruding from one of the first plate (310) or the second plate (320).

5. The electronic device (101) of claim 4,
wherein the protrusion (610, 620) is formed to contact other one among the first plate (310) and the second plate (320).

6. The electronic device (101) of claim 4,
wherein the protrusion (610, 620) is welded to the first wick portion (350).

7. The electronic device (101) of any one of claims 1 to 6,
wherein the first wick portion (350) includes a slit corresponding to the separating structure (335).

8. The electronic device (101) of any one of claims 1 to 7,
wherein the heat spreading member (300) further includes first pillars (410), protruding from the second plate (320) toward the first plate (310) within the first flow path (301) and contacting the first wick portion (350).

9. The electronic device (101) of claim 8,
wherein the first wick portion (350) includes a plurality of holes (440) corresponding to at least a portion of a space between the first pillars (410).

10. The electronic device (101) of any one of claims 1 to 9,
wherein the second plate (320) includes a plurality of recesses formed along the separating structure (335) within the second flow path (302), and
wherein the second wick portion (360) is configured to fill the recesses.

11. The electronic device (101) of any one of claims 1to 10,
wherein the wick structure (340) includes a separating portion (340b) in which pores are not formed, as at least a portion of the separating structure (335).

12. The electronic device (101) of any one of claims 1 to 11, comprising:
a first housing (910) accommodating the heat spreading member (300);
a second housing (920) rotatably coupled with the first housing (910);
a hinge structure (950) connecting the first housing (910) and the second housing (920); and
a heat transfer member (980) extending from the first housing (910) across the hinge structure (950) to the second housing (920);
wherein the heat spreading member (300) is configured such that the first flow path (301) is located closer to the heat transfer member (980) than the second flow path (302).

13. The electronic device (101) of any one of claims 1 to 12,
wherein the second wick portion (360) is configured to fill the second flow path (302) together with the first wick portion (350).

14. The electronic device (101) of any one of claims 1 to 13,
wherein the heat spreading member (300) further includes second pillars (420) protruding from the second plate (320) toward the first plate (310) in the second flow path (302) and contacting the first wick portion (350), and
wherein the second wick portion (360) includes a plurality of through holes (430) for passing the second pillars (420) in the second flow path (302).

15. The electronic device (101) of any one of claims 1 to 14,
wherein the heat spreading member (300) is at least partially bent, and
wherein the separating structure (335) has a curvature by being at least partially bent along the heat spreading member (300).
